(19)

Europäisches
Patentamt
European
Patent Office
Office européen
des brevets

(11) **EP 4 089 484 A1**

(12) **EUROPEAN PATENT APPLICATION**

(43) Date of publication:
**16.11.2022 Bulletin 2022/46**

(21) Application number: **21173654.1**

(22) Date of filing: **12.05.2021**

(51) International Patent Classification (IPC):
**G03F 7/20** (2006.01)

(52) Cooperative Patent Classification (CPC):
**G03F 7/70525**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BOTTEGAL, Giulio**
**5500 AH Veldhoven (NL)**
• **CAO, Xingang**
**5500 AH Veldhoven (NL)**

(74) Representative: **ASML Netherlands B.V.**
**Corporate Intellectual Property**
**P.O. Box 324**
**5500 AH Veldhoven (NL)**

(54) **SYSTEM AND METHOD TO ENSURE PARAMETER MEASUREMENT MATCHING ACROSS METROLOGY TOOLS**

(57)     Methods and systems for determining a model configured to predict values of physical characteristics (e.g., overlay, CD) associated with a patterned substrate measured using different measurement tools. The method involves obtaining a first set of measured data for a first patterned substrates using a first measurement tool, and reference measurements of a physical characteristic. Also, a second set of measured data and virtual data for a second set of patterned substrates measured using a second set of measurement tools is obtained. A set of mapping functions between the second set of measured data and the virtual data are generated. The set of mapping functions is used to the first set of measured data. Then, a model is determined based on the reference measurements and the converted data such that the model predicts values of the physical characteristic that are within an acceptable threshold of the reference measurements.

FIG. 13A

## Description

TECHNICAL FIELD

This description relates to mapping metrics between manufacturing systems.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance.

To overcome these difficulties, sophisticated fine-tuning steps may be applied to the lithographic projection apparatus and/or design layout. These include, for example, but are not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

SUMMARY

Various metrology operations may be used to measure features of a design. If measured on different metrology systems, the data from a metrology operation on one system may not match the data from the same metrology operation on a different system. Advantageously, the present method(s) and system(s) are configured to provide a framework to improve matching between systems by exhaustive use of available system calibration data.

According to an embodiment, a method determining a model configured to predict values of physical characteristics associated with a patterned substrate measured using different measurement tools is provided. The method involves obtaining (i) training data comprising a first set of measured data (e.g., a set of intensity images) associated with a first set of patterned substrates using a first measurement tool (e.g., T1), and reference measurements of a physical characteristic (e.g., overlay, CD) associated with the first set of patterned substrates (ii) a second set of measured data (e.g., another set of intensity images) associated with a second set of patterned substrates that is measured using a second set of measurement tools, the second set of measurement tools being different from the first measurement tool, and (iii) virtual data based on the second set of measured data, the virtual data being associated with a virtual tool. The method generates a set of mapping functions between the second set of measured data and the virtual data, where each mapping function mapping each measured data of the second set of measured data to the virtual data. The method converts, based on the set of mapping functions, the first set of measured data of the training data. The method determines a model based on the reference measurements and the converted first set of measured data such that the model predicts values of the physical characteristic that are within an acceptable threshold of the reference measurements.

In some embodiments, the model may be a machine learning model, an empirical model, or other mathematical models characterized by parameters trained according to the above method.

In some embodiments each of the first measured data and the second measured data comprises signals detected by sensors configured to measure the portion of the second patterned substrate. In some embodiments, each of the first measured data and the second measured data comprises intensities corresponding to light reflected from the portion of the second patterned substrate.

In some embodiments, the reference measurements of the physical characteristic are obtained by measuring the first set of patterned substrates using the SEM or an atomic force microscope (AFM).

In some embodiments, the method may further involve creating, based on the set of mapping functions, recipe of the virtual tool, the recipe comprising configuration of one or more tool characteristics used during a measurement. In some embodiments, the one or more tool characteristic includes, but not limited to a wavelength of the light used for measurements; a pupil shape used for measurements; an intensity of light used for measurements; and/or a grating-to-sensor orientation of a patterned substrate.

According to an embodiment, another method determining a model configured to predict consistent values of physical characteristics associated with a patterned substrate measured using different measurement tools is provided. The method involves obtaining (i) reference measurements of a physical characteristic (e.g., overlay, CD) associated with a first set of patterned substrates, (ii) first measured data associated with a portion of a second patterned substrate using a first measurement tool, and (iii) second measured data associated with the portion of the second patterned substrate using a second measurement tool. The method determines a model by adjusting model parameters based on the first measured data, the second measured data, and the reference measurements to cause the model to predict values of the physical characteristic that are within an acceptable threshold of the reference measurements.

In some embodiments, the physical characteristic comprises at least one of an overlay between a feature on a first layer and a feature on a second layer of the patterned substrate, a critical dimension of features of the patterned substrate, a tilt of the patterned substrate, or an edge placement error associated with the patterned substrate.

In some embodiments, determining of the model involves computing a difference between the first measured data and the second measured data; determining a set of basis functions characterizing the difference data; applying the set of basis functions to the first measured data and the second measured data to generate projected data; and determining the model by adjusting model parameters based on the projected data and the reference measurements to cause the model to predict values of the physical characteristic that are within the acceptable threshold of the reference measurements. In an embodiment, the set of basis functions are determined by a singular value decomposition of the difference data, or principal component analysis of the difference data.

In some embodiments, 2determining of the model involves determining model parameters by satisfying a difference constraint comprising a difference between a first predicted physical characteristic value and a second predicted physical characteristic value, the first predicted physical characteristic value being predicted using the first measured data as input to the model and the second predicted physical characteristic value being predicted using the second measured data as input to the model.

In some embodiments, the model may be a machine learning model, an empirical model, or other mathematical models characterized by parameters trained according to the above method.

In some embodiments each of the first measured data and the second measured data comprises signals detected by sensors configured to measure the portion of the second patterned substrate. In some embodiments, each of the first measured data and the second measured data comprises intensities corresponding to light reflected from the portion of the second patterned substrate.

According to an embodiment, a metrology tool is provided. The metrology tool includes a sensor configured to detect signals associated with a portion of a patterned substrate being measured; one or more processors configured to executing a model trained according to the methods discussed herein. The one or more processors are configured to receive the signals from the sensor; and determine, via a model using the signals as input, values of a physical characteristic associated with the patterned substrate, the model being configured based on measurement data associated with one or more patterned substrates measured using different metrology tools, and reference measurements of the physical characteristic associated with a reference patterned substrate.

In some embodiments, the physical characteristic comprises at least one of an overlay between a feature on a first layer and a feature on a second layer of the patterned substrate, a critical dimension of features of the patterned substrate, a tilt of the patterned substrate, or an edge placement error associated with the patterned substrate.

In some embodiments, the physical characteristic comprises at least one of an overlay between a feature on a first layer and a feature on a second layer of the patterned substrate, a critical dimension of features of the patterned substrate, a tilt of the patterned substrate, or an edge placement error associated with the patterned substrate.

In some embodiments, the detected signal of the metrology tool includes intensities corresponding to light reflected from the portion of the patterned substrate being measured. In some embodiments, each of the detected signal is represented as a pixelated image, one or more pixels have intensity indicative of a feature of the patterned substrate. In an embodiment, the metrology tool is an optical tool configured to measure a portion of the patterned substrate.

According to an embodiment, there is provided a non-transitory computer-readable medium configured for determining a model configured to predict values of physical characteristics associated with a patterned substrate measured using different measurement tools, the medium comprising instructions stored therein that, when executed by one or more processors, cause operations or processes of methods discussed herein.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 depicts a schematic overview of a lithographic apparatus, according to an embodiment.
Figure 2 depicts a schematic overview of a lithographic cell, according to an embodiment.
Figure 3 depicts a schematic representation of holistic lithography, representing a cooperation between three technologies to optimize semiconductor manufacturing, according to an embodiment.
Figure 4 illustrates an example metrology apparatus, such as a scatterometer, according to an embodiment.
Figure 5 illustrates a summary of operations of a present method for determining a mapped intensity metric, according to an embodiment.
Figure 6 illustrates mapping intensity metrics from two manufacturing systems to a reference system such that the intensity metrics from the manufacturing systems can be compared, according to an embodiment.
Figure 7 illustrates mapping (e.g., determining a mapped intensity metric) based on a transformation matrix, according to an embodiment.
Figure 8 illustrates mapping individual intensities directly from different points on a pupil, and mapping corresponding intensities from reciprocal points on the pupil, according to an embodiment.
Figure 9 shows the basic relations between reflectivity and intensity, according to an embodiment.
Figure 10A shows an example of a set of "reference" S, according to an embodiment.
Figure 10B shows an example of input pupils (e.g., pupil intensity images which can be the intensity metrics described herein), according to an embodiment.
Figure 10C shows resulting reflectivity components after mapping, according to an embodiment.
Figure 11 is a flow chart of a method for determining/training a model for predicting measurements of physical characteristics associated with a patterned substrate, the model once trained is used for predicting values of physical characteristics based on measurements provided by any metrology tool, according to an embodiment.
Figure 12 is block diagram illustrating determining and employing the model according to method of Figure 11, according to an embodiment.
Figures 13A-13C are example flow charts of another method for determining/training a model for predicting measurements of physical characteristics associated with a patterned substrate, the model once trained is used for predicting values of physical characteristics based on measurements provided by any metrology tool, according to an embodiment.
Figure 14 is another block diagram illustrating determining and employing a model according to method of Figure 13A, according to an embodiment.
Figure 15 is a block diagram of an example computer system, according to an embodiment.

DETAILED DESCRIPTION

Various metrology operations may be used to measure features of a design. If measured on different metrology systems, the data from a metrology operation on one system may not match the data from the same metrology operation on a different system. For example, in the context of integrated circuits, matching between measured overlay values measured on different overlay measurement systems is often out of specification. A current approach for ensuring that data from different metrology systems is comparable uses the Jones Framework. The Jones-framework is a ray-based framework, which accounts for the polarization state of the light used by the system for measuring (e.g., a light / pupil based metrology system). However, this current approach ignores any phase-shift of the light as it travels through the metrology system and thus it fails to capture phase related differences between systems. Phase effects are a major source of system-to-system matching issues. For example, the objective retardation (a.k.a. alpha-map) and the phase-induced channel leakage for a given system are thought to be causes of the system-to-system matching issues.

Advantageously, the present method(s) and system(s) are configured to provide a generic framework to improve matching between systems by exhaustive use of available system calibration data. These calibration data are assumed to be present in the form of the incoming and outgoing density matrices (e.g., $\rho_{in}$ and $M_{out}$). In the present method(s) and system(s), an intensity metric (e.g., which may, in some embodiments, be and/or include an intensity image (associated with a pupil), an intensity map, a set of intensity values, and/or other intensity metrics) is determined for a manufacturing system (e.g., a light/pupil based system configured to measure overlay continuing with the example above). The intensity metric is determined based on a reflectivity of a location on a substrate (e.g., a wafer and/or other substrates), a manufacturing system characteristic, and/or other information. A mapped intensity metric for a reference system is determined. The reference system has a reference system characteristic. The mapped intensity metric is determined based on the intensity metric, the manufacturing system characteristic, and the reference system characteristic, to mimic the determination of the intensity metric for the manufacturing system using the reference system. In this way, any number of intensity metrics from any number of manufacturing systems may be mapped to this reference system to facilitate comparison of data from different manufacturing systems.

Although specific reference may be made in this text to the manufacture of ICs, and/or metrology related to the manufacture of IC's, the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the method described herein may have many other possible applications in diverse fields such as language processing systems, self-driving cars, medical imaging and diagnosis, semantic segmentation, denoising, chip design, electronic design automation, etc. The present method may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "reticle," "mask," or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array.

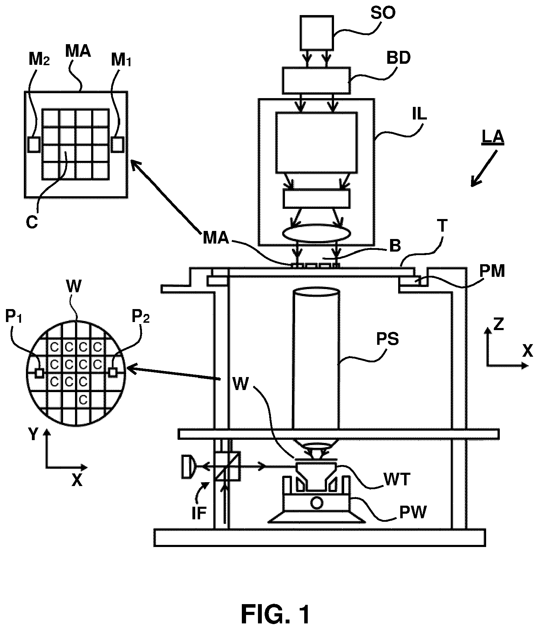

As a brief introduction, Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT configured to hold a substrate (e.g., a resist coated wafer) W and coupled to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

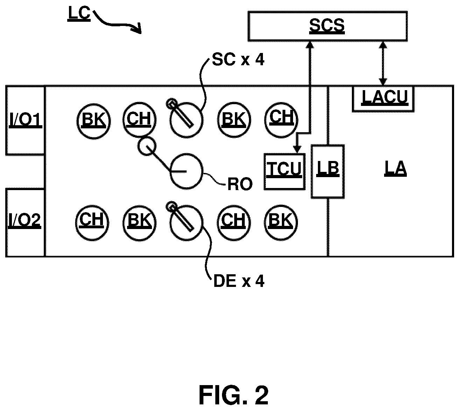

Figure 2 depicts a schematic overview of a lithographic cell LC. As shown in Figure 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W (Figure 1) exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

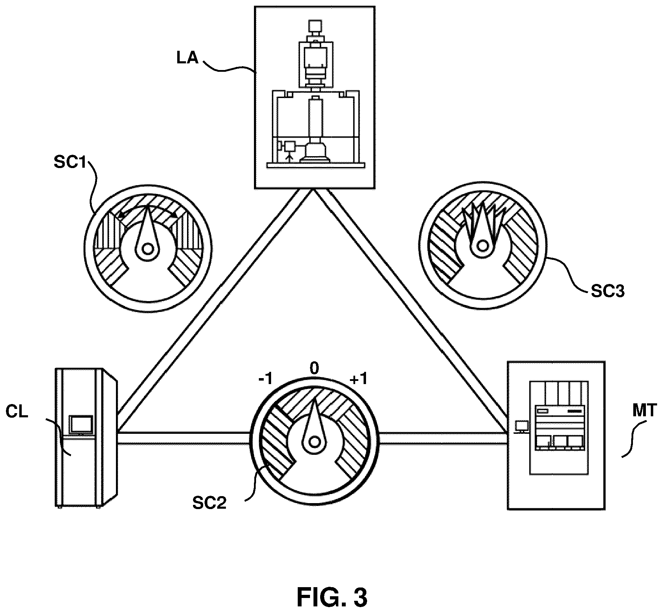

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, a scatterometer MT is an angular resolved scatterometer. In these embodiments, scatterometer reconstruction methods may be applied to the measured signal to reconstruct or calculate properties of a grating and/or other features in a substrate. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In some embodiments, scatterometer MT is a spectroscopic scatterometer MT. In these embodiments, spectroscopic scatterometer MT may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In some embodiments, scatterometer MT is a ellipsometric scatterometer. The ellipsometric scatterometer allows for determining parameters of a lithographic process by measuring scattered radiation for each polarization states. Such a metrology apparatus (MT) emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings and/or other features in a substrate, formed by a lithographic process, commonly in resist, but also after etch processes, for example. Typically the pitch and line-width of the structures in the gratings depend on the measurement optics (in particular the NA of the optics) to be able to capture diffraction orders coming from the metrology targets. A diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

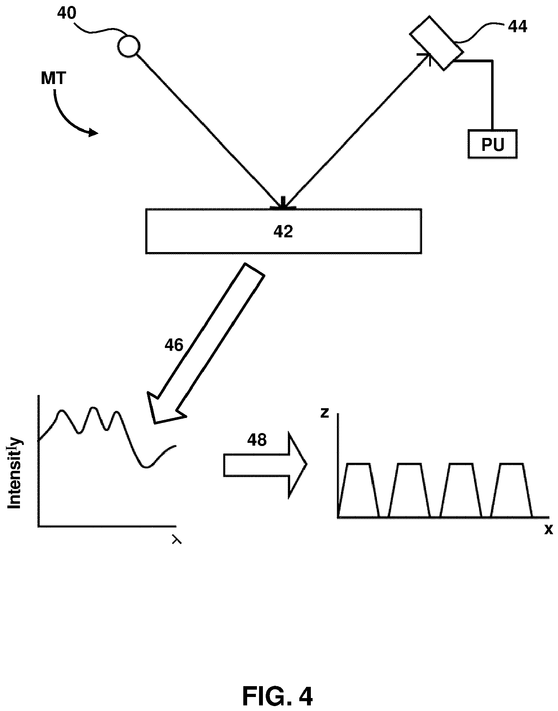

Figure 4 illustrates an example metrology apparatus (tool) MT, such as a scatterometer. MT comprises a broadband (white light) radiation projector 40 which projects radiation onto a substrate 42. The reflected or scattered radiation is passed to a spectrometer detector 44, which measures a spectrum 46 (i.e. a measurement of intensity as a function of wavelength) of the specular reflected radiation. From this data, the structure or profile giving rise to the detected spectrum may be reconstructed 48 by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer, for example.

It is often desirable to be able computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation and/or modeling can be used to determine one or more metrology metrics (e.g., performing overlay and/or other metrology measurements), configure one or more features of the patterning device pattern (e.g., performing optical proximity correction), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

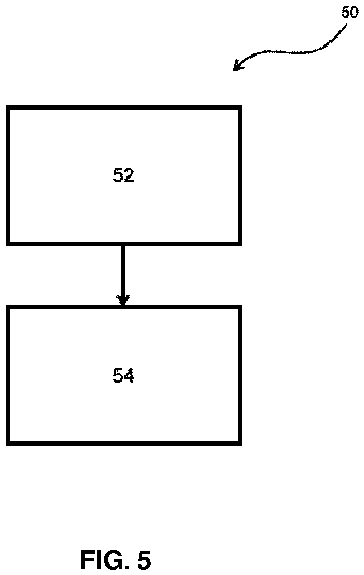

Figure 5 illustrates a summary of operations of a present method 50 for determining a mapped intensity metric that can be used for comparison to similar metrics among manufacturing systems (e.g., manufacturing systems such as those shown in Figures 4, 3, 2, and/or 1). At an operation 52, an intensity metric for a manufacturing system is determined. At an operation 54, a mapped intensity metric for a reference system is determined. Each of these operations is described in detail below. The operations of method 50 presented below are intended to be illustrative. In some embodiments, method 50 may be accomplished with one or more additional operations not described, and/or without one or more of the operations discussed. Additionally, the order in which the operations of method 50 are illustrated in Figure 5 and described below is not intended to be limiting. In some embodiments, one or more portions of method 50 may be implemented (e.g., by simulation, modeling, etc.) in one or more processing devices (e.g., one or more processors). The one or more processing devices may include one or more devices executing some or all of the operations of method 50 in response to instructions stored electronically on an electronic storage medium. The one or more processing devices may include one or more devices configured through hardware, firmware, and/or software to be specifically designed for execution of one or more of the operations of method 50, for example.

As described above, method 50 (and/or the other methods and systems described herein) is configured to provide a generic framework to improve matching between systems using available system calibration data. These calibration data are assumed to be present in the form of the incoming and outgoing density matrices (e.g., $\rho_{in}$ and $M_{out}$) and/or in other forms. The density matrices are related to the Jones matrices of the incoming (from source to target) and outgoing (from target to detector) optical paths of a manufacturing (e.g., metrology) system. A Jones matrix associated with an optical path describes how the optical electric fields propagates along said path. The associated density matrix is defined as the product of the associated Jones matrix with the conjugate transpose (a.k.a. Hermitian transpose, both designated by "†") of that same Jones matrix. More specifically, $\rho_{in} = J_{in}J_{in}^{\dagger}$, and $M_{out} = J_{out}^{\dagger}J_{out}$, with $J_{in}, J_{out}$ the respective Jones matrices.

In method 50, an intensity metric (e.g., which may, in some embodiments, be and/or include an intensity image (associated with a pupil), an intensity map, a set of intensity values, and/or other intensity metrics) is determined for a manufacturing system (e.g., a light/pupil based system). The intensity metric is determined based on a reflectivity of a location on a substrate (e.g., a wafer and/or other substrates), a manufacturing system characteristic, and/or other information. A corresponding mapped intensity metric for a reference system is determined. The reference system has a reference system characteristic. The manufacturing system characteristic and/or the reference system characteristic may be and/or include one or more matrices comprising calibration data and/or other information for a given system (e.g., as further described below). The mapped intensity metric is determined based on the intensity metric, the manufacturing system characteristic, the reference system characteristic, and/or other information, to mimic the determination of the intensity metric for the manufacturing system using the reference system. In this way, any number of intensity metrics from any number of manufacturing systems may be mapped to this reference system to facilitate comparison of data from different manufacturing systems.

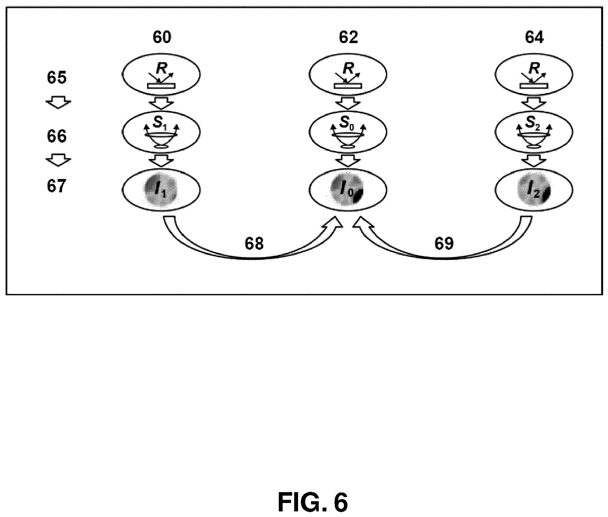

Figure 6 illustrates these principles with three schematic systems 60, 62, and 64. Figure 6 illustrates mapping 68, 69 intensity metrics 67 from two manufacturing systems 60 and 64 to a reference system 62 such that the intensity metrics 67 from the manufacturing systems 60, 64 can be compared. Systems 60 and 64 may be and/or include metrology and/or other manufacturing systems. Such systems may be configured to measure overlay, as just one example, and/or other metrics. Such systems may comprise ASML Yieldstar machines, for example. System 60 is indicated by the subscript "1". System 62 may be a reference system indicated by the subscript "0", and system 64 may be indicated by the subscript "2". The systems 60, 62, and 64 are illustrated as measuring 65 a substrate with a certain (complex valued) reflectivity R. One or more system characteristics 66 are illustrated as being embedded in a system matrix S. The resulting measured pupil intensity 67 (e.g., an intensity metric) is represented by I. As shown in Figure 6, $I_1$ and $I_2$ may be mapped 68, 69 to the reference system 62 to facilitate comparison. The substrate reflectivity itself is not retrieved or reconstructed, but instead the intensity that would have been observed had the intensity metric $I_{1or2}$ been measured on reference system 62 is determined. As shown in Figure 6, intensity metrics from systems 60 and 64 are mapped to reference system 62, and can be compared on that level.

In some embodiments (as described herein), reference system 62 is an idealized system with predetermined characteristics. The predetermined characteristics may include system operating parameters and/or set points, calibration settings and/or other data, and/or other information. In some embodiments, the predetermined characteristics may be measured for a given manufacturing system, electronically obtained from a manufacturing system and/or electronic storage associated with such a system, programmed by a user (e.g., for a virtual system), assigned by a user, and/or may include other information. In some embodiments, the reference system may be a physical system or a virtual system. In some embodiments, the reference system may represent an average or typical system. In some embodiments, the reference system is configured to represent a plurality of different (physical and/or virtual) manufacturing systems. In some embodiments, the reference system is virtual, and the manufacturing system(s) is (are) physical.

Returning to Figure 5 and method 50, at an operation 52, an intensity metric for a manufacturing system is determined (e.g., 67 for systems 60 or 64 shown in Figure 6). The intensity metric (e.g., 67) is determined based on a reflectivity (e.g., 65 shown in Figure 6) of a location on a substrate (and/or reflectivities of several locations on the substrate), a manufacturing system characteristic (e.g., 66 shown in Figure 6), and/or other information. In some embodiments, the manufacturing system characteristic is one or more matrices and/or other arrangements of characteristics that comprise calibration data and/or other data for the manufacturing system. The manufacturing system matrix (or matrices) may include any data that may be uniquely associated with a particular manufacturing system so that any variation caused by a manufacturing system itself is represented in, and/or otherwise accounted for by, the manufacturing system matrix (or matrices).

Method 50 combines different "measurement channels", each channel characterized by an incoming-outgoing-polarization and grating-to-sensor-angle (and wavelength), and/or other information. Each channel corresponds to a different set of density matrices (and system matrices) and also to different measured Intensities I. A channel is an aggregate of measured data, calibration data, and labels. It includes a set of points, each point having a position in the pupil-plane, a measured intensity value (all together forming a pupil intensity image), an incoming density matrix, and an outgoing density matrix.

Said channel also has labels: the associated incoming polarization value, outgoing polarization value, the wavelength, and a grating-to-sensor angle. Additional aspects of operation 52 are further described below in context with operation 54.

At an operation 54, a mapped intensity metric (e.g., 68 and/or 69 in Figure 6) for a reference system (e.g., 62 in Figure 6) is determined. The mapped intensity metric comprises an intensity metric that would have been observed on the reference system given the reflectivity of the location on the substrate. The mapped intensity metric is determined to mimic the determination of the intensity metric for a manufacturing system, but using the reference system. This may facilitate a comparison of data from different manufacturing systems.

By way of a non-limiting example, the intensity metric may be associated with overlay measured as part of a semiconductor manufacturing process, and the mapped intensity metric may be associated with a mapped overlay, such that the mapped overlay can be compared to other mapped overlays from other manufacturing systems also associated with the semiconductor manufacturing process. In some embodiments, the intensity metric is an intensity in an intensity-image (pupil), an intensity image itself, an intensity map, a set of intensity values, and/or other intensity metrics. A mapped overlay (for comparison with other overlay values measured by other manufacturing systems) may be determined by taking all these intensities together (in a linear or non-linear way) with certain weight-factors (e.g., as described below). Overlay is not necessarily associated with a single point in a pupil.

The present system(s) and method(s) make use of the Jones Framework. The Jones framework describes the propagation of polarized light through an optical system in terms of Jones matrices. A Jones matrix of an optical element, $J$, is a 2x2 complex matrix that acts on a 2x1 electric field input-vector $E_{in}$ to produce a 2x1 electric field output-vector $E_{out}$, according to $E_{out} = JE_{in}$. Each electric field E is expressed as a linear combination of two chosen orthogonal unit-(field-) vectors that span a 2D subspace perpendicular to the propagation direction of the light. Said unit vectors constitute the local polarization directions of the light. The Jones matrix of an optical system is the matrix product of the Jones matrices of the associated optical elements.

The reference system has a reference system characteristic and/or other associated information. In some embodiments, the reference system characteristic is a matrix (or a plurality of matrices) that comprises calibration data for the reference system and/or other information. In some embodiments, the reference system characteristic is one or more matrices and/or other arrangements of characteristics that comprise calibration data and/or other data for the manufacturing system. The reference system matrix (or matrices) may include any data that may be uniquely associated with the reference system so that any variation caused by a reference system itself is represented in, and/or otherwise accounted for by, the reference system matrix (or matrices).

The mapped intensity metric is determined based on the intensity metric, the manufacturing system characteristic, the reference system characteristic, and/or other information. In some embodiments, the manufacturing system matrix and the reference system matrix form a transform matrix. The components of the transform matrix "T" are determined by the system matrices of the manufacturing system(s) and the matrices of the reference system.

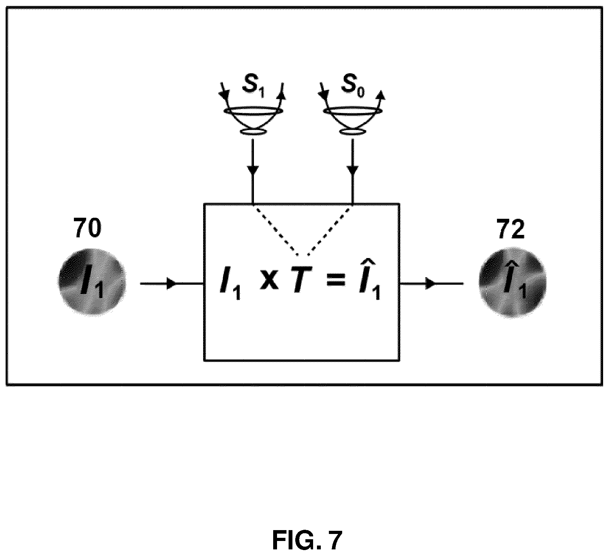

Figure 7 illustrates mapping (e.g., determining a mapped intensity metric) based on a transformation matrix T. The components of the transform matrix T (e.g., $S_1$ and $S_0$ in this example) include the system characteristics (e.g., the matrices and/or other characteristics) of the manufacturing system and the reference system. As described herein, the characteristics and/or the matrices comprise calibration data for the individual systems and/or other information. In some embodiments, a matrix may comprise a 4 x 4 matrix for individual points on a pupil. In some embodiments, the calibration data may be obtained electronically from a system itself (e.g., for the manufacturing system), programmed by a user (e.g., for the reference system), and/or determined in other ways. As shown in Figure 7, in some embodiments, a given intensity metric 70 (e.g., $I_1$) may be multiplied by the transformation matrix T to determine a mapped intensity metric 72.

In some embodiments, determining the mapped intensity metric comprises a linear transform of measured channel intensities. In some embodiments, determining the mapped intensity metric comprises combining pointwise linear transforms of measured channel intensities. Individual measurement channels may be characterized by an incoming-outgoing polarization, a grating to sensor rotation, a wavelength, and/or other parameters. Polarized light comprises a light wave that is vibrating in a single plane. Light may be polarized with a filter and/or with other components. Polarized light comprises a light wave of which the electric field vector oscillates in a single direction (linear polarization) or in a rotating fashion (circular or elliptical polarization). In the case of linearly polarized light, a direction attribute, e.g. H, V, S or P, is used to specify the direction. In the case of circular or elliptical polarized light, a rotational sense and/or ellipticity attribute is used to specify the light. In some embodiments, a grating to sensor rotation may comprise an azimuthal angle between a substrate and a sensor in a manufacturing system used to measure reflectivity, intensity, and/or other parameters. The wavelength may refer to the wavelength of light used by the manufacturing system for measuring the reflectivity, intensity, and/or other parameters.

The incoming-outgoing linear polarization comprises horizontal (in) horizontal (out) (H-H), vertical horizontal (V-H), horizontal vertical (H-V), and/or vertical vertical (V-V). The polarization attribute H or V refers to the linear polarization direction of the light as it (e.g., virtually) travels through the pupil plane of the objective. The H-direction refers to a first chosen direction in the pupil plane. The V direction refers to a second direction perpendicular to the first direction. Said filters to select incoming and outgoing H and V polarizations are aligned accordingly. In some embodiments, the incoming-outgoing linear polarization comprises S-P, where S ("Senkrecht") and P (Parallel) form machine independent polarization directions. The S and P polarization directions are defined in relation to the plane spanned by the direction of the (incoming or outgoing) light and the surface normal of the target. The S direction refers to a first direction perpendicular to said plane. The P direction associated with the incoming light is perpendicular to said S direction and perpendicular to the propagation direction of the incoming light. The P direction associated with the outgoing light is perpendicular to said S direction and perpendicular to the propagation direction of the outgoing light. In some embodiments, the grating to sensor rotation comprises a set of given angles (these can be any angles whatsoever), and the set of given angles plus 180 degrees.

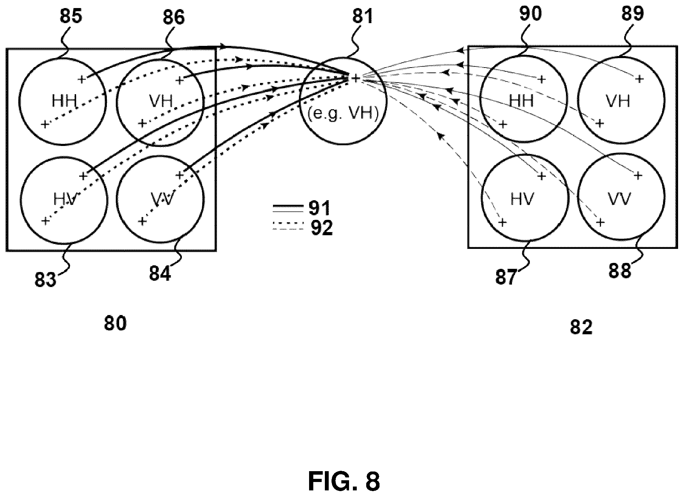

In some embodiments, determining the mapped intensity metric comprises mapping individual intensities directly from different points on a pupil, and mapping corresponding intensities from reciprocal points on the pupil. For example, Figure 8 illustrates mapping individual intensities directly from different points 80 on a pupil, and mapping corresponding intensities from reciprocal points 82 on the pupil. Figure 8 shows two sets of points 80 and 82 for four pupils 83, 84, 85, 86, 87, 88, 89, 90 (each pupil in each set labeled individually) at grating-to-sensor rotations (GTS) of 0 (e.g., set of points 80) and 180 degrees (e.g., set of points 82), for a certain wavelength of light. In this example, the mapped pupil (intensity) 81 (e.g., the mapped intensity metric) is HV (H-in, V-out). In this example, it is assumed that diffraction orders are absent. As shown in Figure 8, in total, 16 points may contribute when determining the indicated mapped pupil point: the 8 "direct" points 91, being at the same position in the pupil as the mapped point, and the 8 "reciprocal" points 92 being at the opposite position in the pupil. The reciprocal points 92 can be included in the mapping because of reciprocity relations that hold if the direction is reversed. These relations hold in the reflectivity domain.

In some embodiments, determining the mapped intensity metric comprises weighting the intensities directly mapped from the different points on the pupil, and the corresponding intensities from the reciprocal points on the pupil. The weighting is based on the calibration data in the manufacturing system matrix and/or the reference system matrix, a corresponding vectorized form of the reflectivity (as described below), and/or other information. Individual weights are determined based on an incoming polarization, an outgoing polarization, a grating to sensor rotation, a reciprocity, a diffraction order, and/or other parameters associated with a given intensity metric.

For example, the individual mapped points indicated by arrows shown in Figure 8 may contribute different weights to the mapped intensity metric 81. The weights may depend on the calibration data in the manufacturing and/or reference system matrix S. Individual weights may be adjusted by a user and/or have other characteristics. Continuing with this example, the same connections, but with different weights, may be made if a different pupil point is chosen for mapping, e.g. HH. It should be noted that all measured pupils (e.g., co-pol and cross-pol) may be involved in a given mapping. As illustrated in Figure 8, two types of points are involved: direct points 91 and reciprocal points 92. Also, more than one grating-to-sensor rotation may be involved.

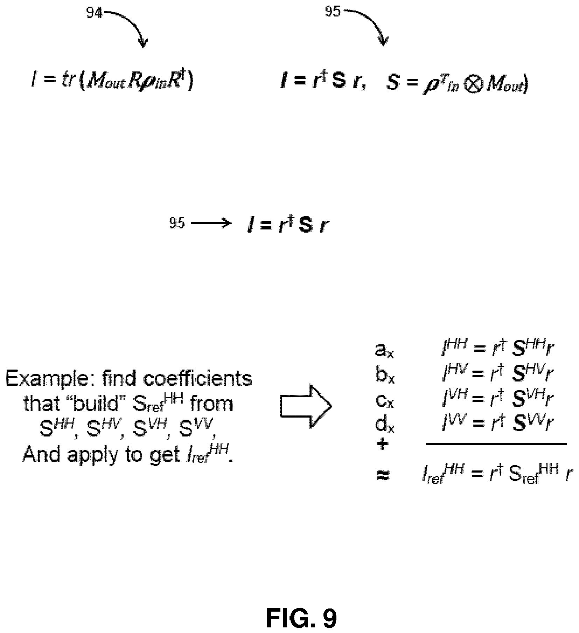

Figure 9 shows relations 94 and 95 between reflectivity R and intensity I (e.g., an intensity metric). Relation 94 is directly expressed in terms of 2x2 Hermitian density matrices $\rho_{in}$ and $M_{out}$, which include the calibration data for the manufacturing system that generated the intensity (e.g., intensity metric). In the expression for I, the manufacturing system state is entangled with the reflectivity R. The system state is characterized/made-up by $\rho_{in}$ and $M_{out}$. By "entangled", we mean that in this equation they appear as two separate entities as a product with "R" in between. A single matrix S that combines both $\rho_{in}$ and $M_{out}$ in a single entity enables making linear combinations, for example. In these expressions, "†" stands for "conjugate transpose", or "Hermitian transpose". "T" stands for "transpose". Relation 94 can be written into the form shown in relation 95, using the (manufacturing) system matrix S, being the Kronecker product of $\rho_{in}$ and $M_{out}$. Now S has become a 4x4 Hermitian matrix, and r is the vectorized form of the reflectivity R. Note that $\rho_{in}$ and $M_{out}$, and hence S depend on incoming polarization, outgoing polarization, grating-to-sensor rota-

$$r = \begin{pmatrix} r1 \\ r2 \\ r3 \\ r4 \end{pmatrix}$$

tion, diffraction order, etc. If then $r^{\dagger}$ = (r1,r2,r3,r4)*, with * denoting the complex conjugate.

As a reminder, in relation 95, intensity I (e.g., an intensity metric) is determined by a manufacturing system (e.g., as described above), S is a system matrix (e.g., comprising one or more manufacturing characteristics as appropriate), and the reflectivity r is unknown (and need not be known). An advantage of using the system matrix S is that the (manufacturing) system properties only enter into the mathematics once, and in a linear way. This enables making linear combinations of sets of equations, even if the actual reflectivity R or r is unknown.

Figure 9 shows a mathematical principle associated with the present method(s) and system(s). In relation 95, the system matrix S is "anonymous". In reality it is associated with an incoming polarization, an outgoing polarization, a grating-to-sensor rotation, reciprocity, a diffraction order, and/or other calibration information. An additional label may be provided to indicate whether S is from the refence system ("ref" label) or from a manufacturing system (no label). Similarly, the intensity I may be labelled with incoming polarization, outgoing polarization, grating-to-sensor rotation, and/or other calibration information. A "ref' label may indicate a mapped intensity (metric), i.e. the intensity (metric) that would have been expected to be determined on the reference system.

In this example, only the incoming and outgoing polarizations are used and it is assumed that four pupils are measured: HH, HV, VH, and VV. Reciprocity is not taken into account in this example. The four mapped pupils with the same polarization labels (and label "ref') are determined. There are four expressions (a, b, c, d) corresponding to the four polarization states of I. Taking linear combinations of these equations comprises taking linear combinations of the manufacturing system matrix S (or matrices) on one side (without the need to know r), and the same linear combinations of I on the other side. For each mapped polarization label the linear combinations are sought such that the resulting combination of the actual system matrices S approaches the corresponding reference system matrix with that same mapped polarization label (HH in the example). The linear combination can be optimized for instance with respect to a minimal Frobenius norm of the difference between the combination of manufacturing system matrices and the corresponding reference system matrix. Also other choices can be made. Finally, the linear combination is applied to the intensities I to yield the mapped (or "reference") intensity. Carrying out the procedure for other mapped polarization labels gives the mapping matrix T that transforms measured intensities to mapped intensities. The mapping operation (e.g., operation 54 shown in Figure 5 - determining the mapped intensity metric) is a pointwise operation involving points at the same pupil-position and in the more generic case also from the opposite (reciprocal) position.

In some embodiments, a "default" use case for the present system(s) and method(s) may be to map to a reference system that somehow resembles the actual manufacturing systems used. Typically, an idealized version of such a system is taken for reference. However, the principles described herein can also be used to define a (hypothetical and/or virtual) refence system that may be difficult to make in reality. In doing so it may be possible to extract intrinsic (semiconductor manufacturing) stack properties that virtually do not depend on any physical manufacturing system. The intrinsic optical stack properties are usually expressed in terms of a complex reflectivity matrix. The elements of this matrix act on the S and P polarization components of the light, where S ("Senkrecht") and P (Parallel) form machine independent polarization directions, only depending on the direction of the incoming/outgoing light.

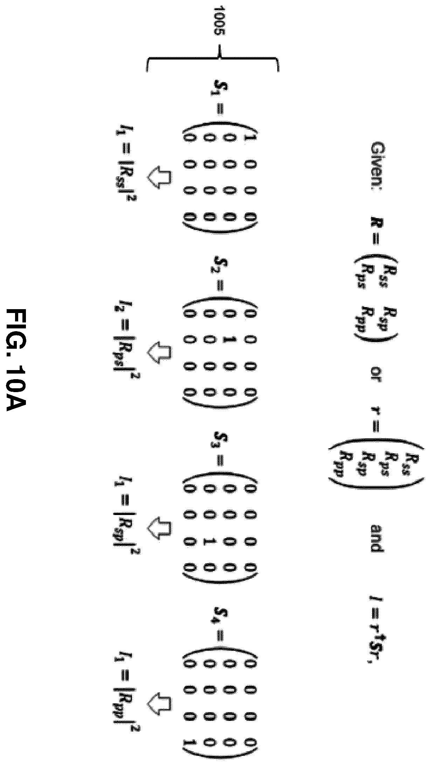

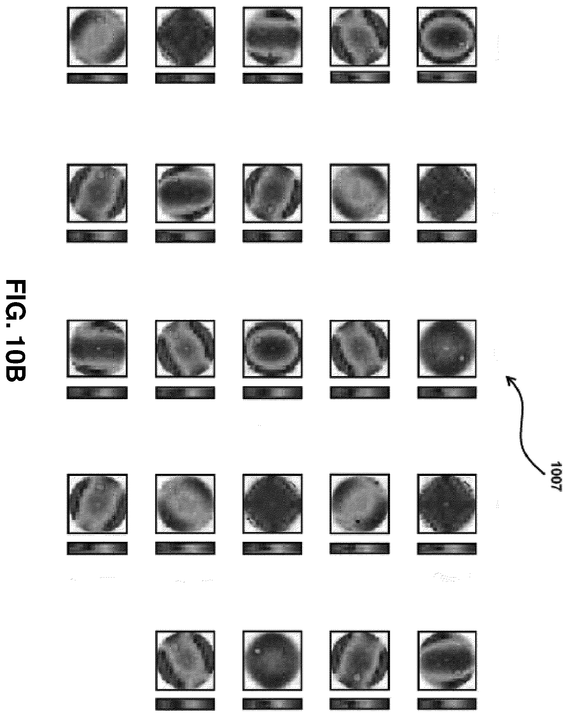

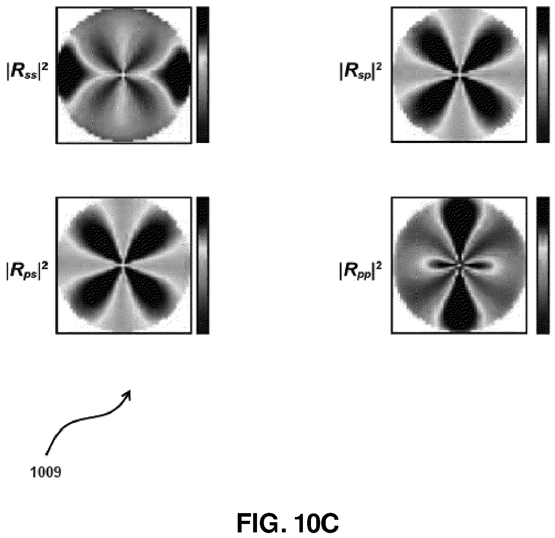

Figure 10A shows an example of a set 1005 of reference system S matrices that, if mapped to, directly provide the norm(s) of the reflectivity matrix in an SP base. For example, $S_1$ is associated with an S-S polarization, $S_2$ is associated with a P-S polarization, $S_3$ is associated with an S-P polarization, and $S_4$ is associated with a P-P polarization. An example of input pupils 1007 (e.g., pupil intensity images which can be the intensity metrics described herein) is shown in Figure 10B. Note that the pupil-set contains all HH, HV, VH, VV polarizations and six grating-to-sensor rotations: 0, 21, 67, 180, 201 and 247 degrees. Figure 10C shows the resulting reflectivity components 1009 after mapping.

Returning to Figure 5, as described above, the operations of method 50 are intended to be illustrative. In some embodiments, method 50 may be accomplished with one or more additional operations not described, and/or without one or more of the operations discussed. For example, in some embodiments, method 50 may include retrieving (e.g., electronically accessing, downloading, receiving an electronic communication, etc.) a manufacturing system matrix (e.g., comprising first calibration data for a manufacturing system) and/or a reference system matrix (e.g., comprising second calibration data for a virtual system), determining a reflectivity of a location on a substrate for the manufacturing system, comparing a mapped intensity metric from one manufacturing system to a corresponding mapped intensity metric from a different manufacturing system, and/or other operations.

In-device metrology (IDM) focuses on measuring physical characteristics such as stack parameters (e.g., overlay) associated with a substrate that are of interest. In existing technology, a model may be trained to determine the physical characteristics of a substrate from measured data (e.g., pupil data) obtained from a metrology tool such as an optical tool. To generate the model, a data-driven approach is used in order to learn how to associate physical characteristics to measured data, using substrates whose reference values of the physical characteristics of interest are given.

Typically, the measured data associated to these substrates all originate from a single measurement tool. But it is expected that the trained model provides consistent physical characteristics measurements even it measured with different metrology tools used in the semiconductor manufacturing. However, this is not always the case, as small differences in the hardware components of the metrology tools can make a model trained on a tool be unsuitable for another tool, generating significant tool-to-tool matching issues.

In some embodiments, a method such as *observable mapping* was developed to improve tool optical calibration and therefore tool-to-tool matching. However, in some cases, observable mapping may face challenges when measuring particular circuit patterns. For example, in circuit patterns such as 3D-NAND stacks, there exists high-frequency components in the optical signals obtained from the metrology tool. These high frequency components make calibration via observable mapping difficult. In another example, such as circuit pattern including DRAM layers there may be difference in measurements from different tools due to hardware mismatch between the metrology tools coupled with a weak signal providing information about the physical characteristics.

For mitigating above matching issues (e.g., related to 3D-NAND, DRAM, etc.), a series of time-consuming steps and engineering resources may be required. For example, the mitigation may require a user to measure additional 10-20 patterned substrates (i.e., in addition to the substrates used to train the model) on the different tools that are meant to give matching measurements.

In the present disclosure, solutions for determining improved tool-to-tool matching issue related to determining physical characteristics of a patterned substrate. These solutions employ data-driven approaches for model training and recipe creation by adding a number of steps (different from existing training and recipe creation methods) in a procedure to develop a trained inference model suitable for different metrology tools, ensuring physical characteristics measurements match across different tools.

Typically, a metrology recipe creation involves using a number of substrates measured on a single metrology tool. For these substrates corresponding reference data of the physical characteristics is also made available to allow for data-driven model training. On the other hand, the methods herein include calibration substrates that are measured by different tools. For example, the different tools may be a first optical metrology tool and a second optical metrology tool used in the semiconductor manufacturing process. The details of the methods for training a model and recipe creation are further discussed as follows.

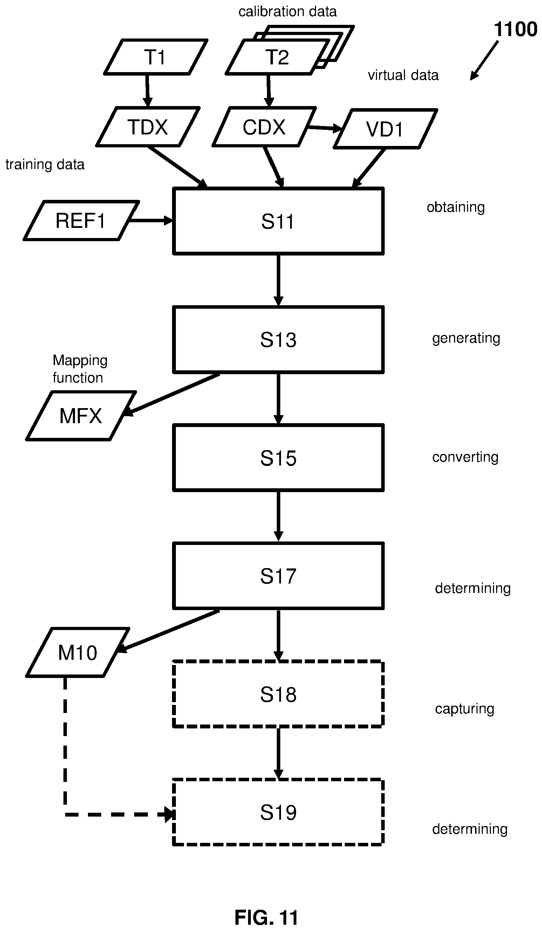

Figure 11 is a flow chart of a method for determining/training a model for predicting measurements of physical characteristics associated with a patterned substrate. The model once trained is used for predicting values of physical characteristics based on measurements provided by any metrology tool, according to an embodiment. The method herein can be used to determine a model configured to predict values of physical characteristics associated with a patterned substrate measured using different measurement tools (also referred as metrology tools). For example, the model is configured to receive measurements such as pupil data to determine CD, overlay or other physical characteristics of features patterned on the substrate. In an embodiment, the model may be configured to generate some recipe information associated with the metrology tool. For example, the model may generate recipes comprising values of wavelength, intensity, etc. of the light used by an optical metrology tool used for measuring the substrate. In an embodiment, the recipe for a first tool may be different from a second tool so that even when a patterned substrate is measured by different tools, consistent measurements of physical characteristics may be obtained. The method includes following operations or processes according to an embodiment.

Process S11 involves obtaining (i) training data comprising a first set of measured data TDX associated with a first set of patterned substrates using a first measurement tool T1, and reference measurements REF1 of a physical characteristic associated with the first set of patterned substrates (ii) a second set of measured data CDX (also referred as calibration data) associated with a second set of patterned substrates (also referred as calibration wafers) that is measured using a second set of measurement tools T2, the second set of measurement tools T2 being different from the first measurement tool T1, and (iii) virtual data VD1 based on the second set of measured data CDX, the virtual data VD1 being associated with a virtual tool. In one embodiment, the second set of measurement tools includes the first measurement tool T1 and additional tools different from the tool T1.

In an embodiment, the first set of measured data TDX comprises measured data in a form of signals detected by a sensor the first measurement tool T1 configured to measure a portion of a patterned substrate of the first set of patterned substrates. In an embodiment, the first set of measured data TDX includes a first measured data detected by the sensor the first measurement tool T1 configured to measure a portion of a first patterned substrate of the first set of patterned substrates; and a second measured data detected by the sensor the first measurement tool T1 configured to measure a portion of a second patterned substrate of the first set of patterned substrates.

In an embodiment, each measured data of the first set of measured data TDX comprises intensities corresponding to light reflected from a portion of a particular patterned substrate of the first set of patterned substrates. In an embodiment, the intensities comprise pixel intensities of a pixelated image generated by using a pupil for measuring the portion of the particular patterned substrate of the first set of patterned substrates.

In an embodiment, the physical characteristic includes, but not limited to, an overlay between a feature on a first layer and a feature on a second layer of a patterned substrate; and/or a critical dimension of features of a patterned substrate, a tilt of the patterned substrate, or an edge placement error associated with the patterned substrate.

In an embodiment, the reference measurements REF1 are obtained using a reference tool, the reference tool being different from the first measurement tool T1. In an embodiment, the reference tool is a scanning electron microscope (SEM), or an atomic force microscope (AFM). For example, the reference measurements REF1 of the physical characteristic (e.g., overlay) are obtained by measuring the first set of patterned substrates using the SEM or an atomic force microscope (AFM). In an embodiment, the reference measurements REF1 may be in the form of self-reference targets (also called as programmed patterned substrates), for example, in an alignment radiation source (ASR).

In an embodiment, the virtual data VD1 is determined by applying a mathematical operation between each of the second set of measured data CDX. In an embodiment, the mathematical operation comprises an averaging operation or a weighted averaging operation applied to the second set of measured data CDX. As the virtual data VD1 may be generated based on the calibration data CDX, the virtual data VD1 comprises variations caused by different tool hardware or settings. In an embodiment, based on the mathematical operation, the virtual data VD1 may include common aspects related to the different tools, and filter out uncommon aspects (e.g., variations due to difference in recipes, hardware, etc.).

Process S13 involves generating a set of mapping functions MFX between the second set of measured data CDX and the virtual data VD1, each mapping function mapping each measured data of the second set of measured data CDX to the virtual data VD1. In an embodiment, the set of mapping functions MFX may be linear functions that maps one data point (e.g., a pixel value of measured data CDX) to a corresponding data point in the virtual data VD1.

In an embodiment, generating of the set of mapping functions MFX involves mapping each measured data of the second set of measured data CDX to the virtual data VD1, each mapping function providing a means to represent each measured data as if measured by the virtual tool. In an embodiment, generating of the set of mapping functions MFX (e.g., MF1 and MF2) involves determining a function for mapping each measured data of the second set of measured data CDX to the virtual data VD1. In an embodiment, the mapping function may be determined using any appropriate data mapping method such as using a least square. In an embodiment, each measured data and the virtual data VD1 are represented as pixelated images.

For example, the mapping function MFX may be a linear function configured to map a particular measured data to the virtual data VD1, a non-linear function configured to map a particular measured data to the virtual data VD1, or other types of functions. For example, MF1 is a linear map between pixel values of a first measured data and pixel values of virtual data VD1, and MF2 is another linear map between pixel values of a second measured data and pixel values of virtual data VD1.

Process S15 involves converting, based on the set of mapping functions MFX, the first set of measured data TDX of the training data. In an embodiment, the converting operation causes the first measured data TDX to be mapped to the virtual tool while incorporating (via the mapping functions) effects of variations in the tools. As such, when the converted data is used for training the model, the trained model predictions (e.g., overlay values) correspond as if determined using the virtual tool. Process S17 involves determining a model M10 based on the reference measurements REF1 and the converted first set of measured data TDX such that the model M10 predicts values of the physical characteristic that are within an acceptable threshold (e.g., within 10% range) of the reference measurements REF1.

In an embodiment, determining of the model M10 is an iterative process. Each iteration may involve predicting, via a base model configured with initial values of model parameters and using the converted first set of measured data TDX as input, values of the physical characteristic associated with the first set of patterned substrates. The predicted values of the physical characteristic (e.g., CD, overlay, etc.) are compared with the reference measurements REF1. In an embodiment, the comparison involves determining a difference between the predicted values and the reference measurements REF1. Based on the comparison, the initial values of the model parameters are adjusted to cause the predicted values (e.g., CD, overlay, etc.) to be within the acceptable threshold of the reference measurements REF1, wherein the adjusted model parameters configure the model M10 for predicting values of the physical characteristic for any measurement tool.

In an embodiment, the method 1100 further involves creating, based on the set of mapping functions MFX, recipe of the virtual tool, the recipe includes configuration of one or more tool characteristics used during a measurement. In an embodiment, the one or more tool characteristics includes, but not limited to a wavelength of the light used for measurements; a pupil shape used for measurements; an intensity of light used for measurements; and/or a grating-to-sensor orientation of a patterned substrate.

In an embodiment, the method 1100 further includes transforming, based on the trained model M10 and the set of mapping functions MFX, a recipe of the virtual tool associated with the virtual data VD1 to recipes associated with the first measuring tool and the second measuring tool. In an embodiment, each recipe causes the respective tool to provide consistent measurements. For example, a first recipe includes characteristics associated with the first measurement tool T1, and a second recipe includes characteristics associated with the second measurement tool (e.g., a tool of T2).

In an embodiment, the method 1100 may further include process S18 for capturing, via a metrology tool, signals associated with a portion of a patterned substrate; and process S19 for executing the trained model M10 using the captured signals as input to determine measurements of the physical characteristic associated with the patterned substrate.

In an embodiment, the process S19 further includes converting, via a mapping function from the set of mapping function corresponding to the metrology tool being used, the signals; and executing the trained model using the converted signals as input to determine measurements of the physical characteristic associated with the patterned substrate. For example, the metrology tool captures an image of a portion of the patterned substrate. The captured image can be used as an input to the trained model M10 that is configured using a mapping function (e.g., MF1) corresponding to the metrology tool, so that the model M10 can predict overlay values associated with patterns printed on the patterned substrate.

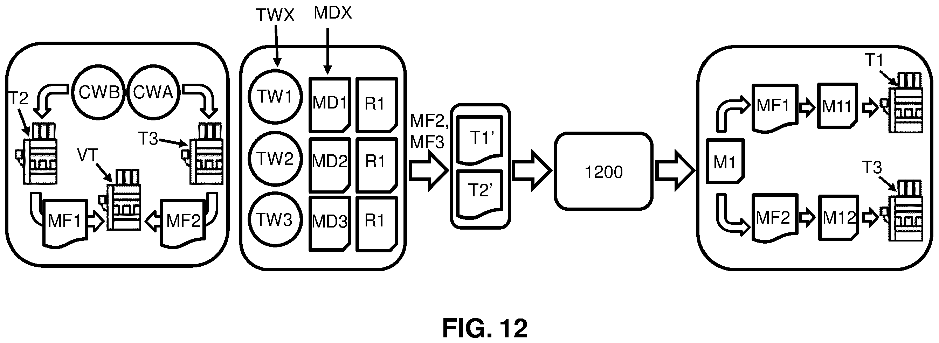

Figure 12 is block diagram illustrating determining and employing the model according to the method 1100, according to an embodiment. In Figure 12, calibration data may be obtained by measuring the calibration wafers CWA and CWB (an example of the second set of measured data CDX) using two different metrology tools. For example, a first calibration wafer CWA may be measured using an optical metrology tool T2, and a second calibration wafer CWB may be measured using another optical metrology tool T3. In another example, the first calibration wafer CWA may be measured using both optical metrology tools T2 and T3 to generate measured data C1 and C2 (not illustrated), respectively. Similarly, the second calibration wafer CWB may be measured using the optical metrology tools T2 and T3 to generate measured data C3 and C4 (not illustrated). In one embodiment, the measured data may be represented as intensity images obtained from reflected light from a portion of the substrates CWA and CWB. In the above example, settings or measurement recipes used with the tools T2 and T3 may be same or different. For example, a first recipe involves obtaining pupil data or intensity image using a 400-millimeter wavelength, and a second recipe involves obtaining pupil data or intensity image using a 700-millimeter wavelength.

Based on the calibration data related to wafers CWA and CWB, virtual data may be generated. For example, an average, or linear combination of the calibration data may be computed to generate the virtual data. In an embodiment, such virtual data may be considered to be associated with a virtual tool VT. A virtual setting or recipe may also be computed based on the recipes of the tools T2 and T3 or based on the virtual data. As such, when the virtual tool is considered to be configured according to the virtual recipe, it generates the virtual data.

As shown in Figure 12, the measured data for the wafer CWA obtained using the tool T2 is mapped to the virtual data, and the other measured data for the wafer CWB obtained using the tool T3 is also mapped to the virtual data. In an example, a first mapping function MF2 maps the measured data of the wafer CWA to the virtual data, and a second mapping function MF3 maps the measured data of the wafer CWB to the virtual data. For example, the mapping functions MF2 and MF3 may be a linear function determined using a least square fitting method. In an example mapping, the measured data may be pupil data (e.g., intensity values of an image obtained from reflected light from a portion of the substrate CWA) that are mapped to pixel intensities of the virtual data. Similarly, the other measured data may be another pupil data related to the wafer CWB that are mapped to pixel intensities of the virtual data. The mapping between pixel intensities may be a linear function.

Furthermore, training data comprising measured data MDX associated with wafers TW1, TW2, and TW3, and reference data R1 (e.g., overlay values) corresponding to each of the wafers TW1-TW3 may be obtained. For example, the measured data MDX includes a first pupil data MD1, a second pupil data MD2, and a third pupil data MD3 obtained by light reflected from a portion of the wafers TW1, TW2, and TW3, respectively. Furthermore, the training data includes reference data R1 such as overlay values associated with wafers TW1, TW2, and TW3. In an embodiment, the reference data R1 may be obtained using a tool such as SEM or AFM.

In an embodiment, the measured data MDX correspond to a particular tool, and may not correspond to measurements that could have been obtained if the wafters TW1-TW3 were measured using the virtual tool. As such, the measured data MDX is converted using the mapping functions MF2 and MF3. The converted data (e.g., T1' and T2') of MDX along with the reference data R1 is further used for determining a model. For example, a process 1200 may be a machine learning, or data fitting process based on the model type (e.g., a machine learning model, or an empirical model). In an embodiment, the process 1200 is configured to determine model parameters of the model using the converted data T1' and T2' as input for making predictions of physical characteristics. The predicted characteristic values may be compared with the reference data R1 to adjust the model parameters. For example, a gradient based adjustment of model parameters may be employed to cause an error between the predictions and reference data to be minimized. The process 1200 generates a trained model M1 configured to predict values of the physical characteristics of interest.

In an embodiment, the model M1 may be further combined with the mapping functions such as MF2 and MF3 to generate models M11 and M12. The model M11 may be employed when determining physical characteristics using the metrology tool T2, while model M12 may be employed when determining physical characteristics using the metrology tool T3.

In an embodiment, the model M1 may be trained to determine measurement recipes to be applied by a metrology tool so that consistent measurements from different tools may be obtained. The model M11 may be employed for determining a recipe for the metrology tool T2, while model M12 may be employed for determining a recipe for the metrology tool T3.

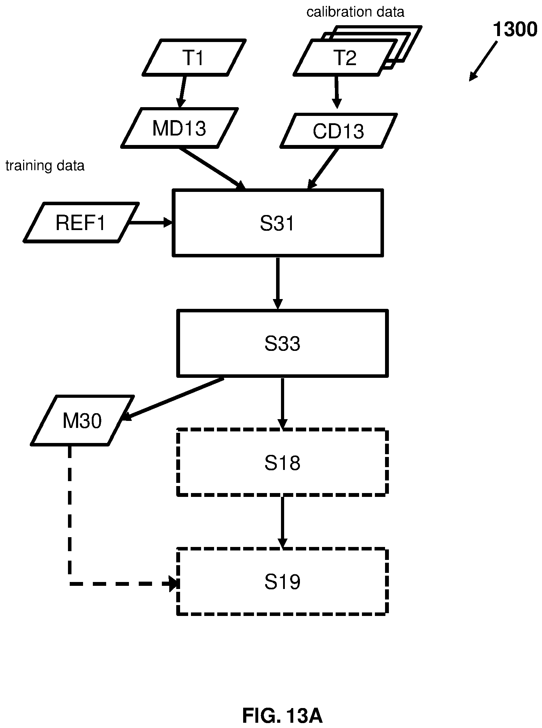

Figure 13A is a flow chart of another method for determining/training a model for predicting measurements of physical characteristics associated with a patterned substrate, the model once trained is used for predicting values of physical characteristics based on measurements provided by any metrology tool, according to an embodiment. Example implementation of the method includes processes S31 and S33 discussed in detail below.

Process S31 involves obtaining (i) reference measurements REF1 of a physical characteristic associated with a first set of patterned substrates, (ii) first measured data MD13 associated with a portion of a second patterned substrate using a first measurement tool T1, and (iii) second measured data CD13 associated with the portion of the second patterned substrate using a second measurement tool T2.

In an embodiment, each of the first measured data MD13 and the second measured data CD13 comprises signals detected by sensors of tools T1 and T2, respectively, configured to measure the portion of the second patterned substrate. In an embodiment, each of the first measured data MD13 and the second measured data CD13 comprises a pixeled image, wherein each pixel has intensity corresponding to light reflected from the portion of the second patterned substrate.

Process S33 involves determining a model M30 by adjusting model parameters based on the first measured data MD13, the second measured data CD13, and the reference measurements REF1 to cause the model M30 to predict values of the physical characteristic that are within an acceptable threshold of the reference measurements REF1. In an embodiment, the model M30 is a machine learning model (e.g., CNN), or an empirical model.

In an embodiment, the reference measurements REF1 are obtained using a reference tool, the reference tool being different from the tools T1 and T2. In an embodiment, the reference tool is a scanning electron microscope (SEM), or an atomic force microscope (AFM). For example, the reference measurements REF1 of the physical characteristic (e.g., overlay) are obtained by measuring the first set of patterned substrates using the SEM or an atomic force microscope (AFM).

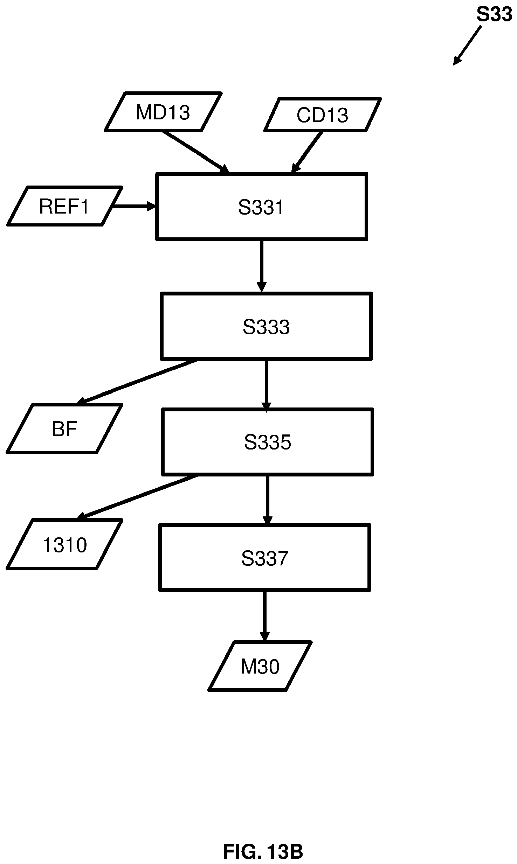

In an embodiment, the process S33 of determining of the model M30 involves example operations S331, S33, S335, and S337, as shown in Figure 13B.

Step S331 involves computing a difference between the first measured data MD13 and the second measured data CD13. As an example, the measured data may be pupil data such as an intensity image created by light reflecting from a portion of the substrate being measured. Accordingly, for measurements from two different tools, a pupil-to-pupil difference between measurements is computed as a pupil difference: $P_\Delta = P_1 - P_2$, where $P_1$ represents the first measured data MD13 and $P_2$ represents the second measured data CD13.

Step S333 involves determining a set of basis functions BF characterizing the difference data (e.g., as the pupil difference $P_\Delta$). In an embodiment, the set of basis functions BF are determined by a single value decomposition (SVD) of the difference data, or principal component analysis (PCA) of the difference data. The decomposition methods SVD and PCA are only exemplary and the present disclosure is not limited to a particular set of basis function or a decomposition method.

In an embodiment, the singular value decomposition of the obtained pupil difference data may be computed as follows:

$$P_\Delta = U_\Delta S_\Delta V_\Delta^T,$$

$$\widetilde{U}_\Delta = U_\Delta(:,1:k)$$

In the above equation, matrix $U_\Delta$ represents components or a set of basis functions that explain the difference data. Matrix $\widetilde{U}_\Delta$ represents a filter which you construct by looking at a difference between the two tools. The term $k$ represent the first "k" columns of the matrix $U_\Delta$ that account for a desired amount (e.g. more than 80%) of the total energy or variation in pupil difference data. In an embodiment, $\widetilde{U}_\Delta$ represents a set of coefficients of the set of basis functions BF (e.g., principal components or other basis functions) that account for the desired amount (e.g., more than 80%) of the total energy or pupil data. In this example, the pupil data difference is a linear combination of these the column of this matrix. In one example, matrix $V_\Delta$ represents the components or the set of basis functions that are orthonormal to $U_\Delta$. In another example, the matrices U and V may be in different spaces that are not necessarily orthogonal.

Step S335 involves applying the set of basis functions BF to the first measured data MD13 and the second measured data CD13 to generate projected data 1310. For example, project the pupil data (e.g., MD13) of the training wafers (e.g., TW1 and TW2) on the subspace orthogonal to $\widetilde{U}_\Delta$ using following equation:

$$P_{pr} = (1 - \widetilde{U}_\Delta \widetilde{U}_\Delta^T) P$$

The above projection indicates that when the pupil data from the training wafers is projected using above projection operation, the pupil data is cleaned from signals that are different in the two tools (e.g., T1 and T2). In other words, filter out the signals that are not common between the two tools. Hence, when the projected data is used for training the model, the trained model will not be sensitive to these differences. So, the model will not associate the tool differences to the values of the physical characteristics (e.g., overlay). In an embodiment, the above process may be applied for any product. For example, a product related to memory, a circuit performing a desired function related to an application, etc. In an embodiment, above process may be applied every time a product change.

Step S337 involves determining the model M30 by adjusting model parameters based on the projected data 1310 (e.g., $P_{pr}$) and the reference measurements REF1 to cause the model M30 to predict values of the physical characteristic that are within the acceptable threshold of the reference measurements REF1.

In an embodiment, the process S33 of determining of the model M30 involves determining model parameters by satisfying a difference constraint comprising a difference between a first predicted physical characteristic value and a second predicted physical characteristic value, the first predicted physical characteristic value being predicted using the first measured data MD13 as input to the model M30 and the second predicted physical characteristic value being predicted using the second measured data CD13 as input to the model M30.

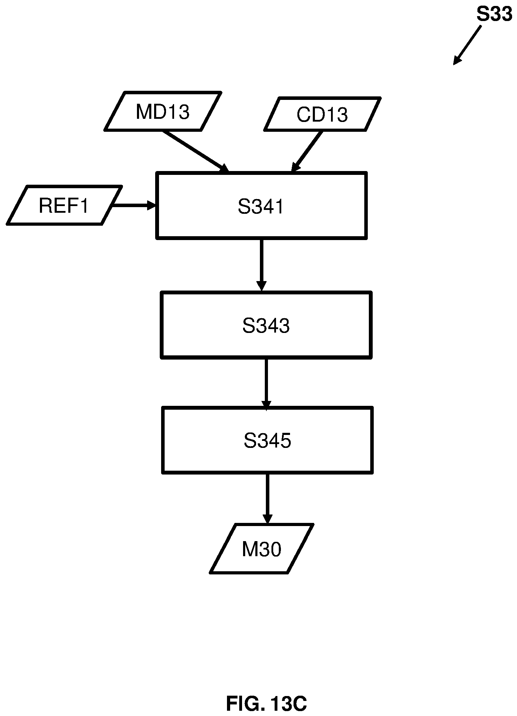

In an embodiment, the process S33 of determining of the model M30 involves example steps S341, S343, and S345, as shown in Figure 13C. In an embodiment, determining the model M30 is an iterative process. Step S341 involves determining, via a base model configured with initial values of the model parameters and using the first measured data MD13 and the second measured data CD13 as input, predicted physical characteristic values associated with the second patterned substrate. Step S343 involves determining, based on the predicted physical characteristic values, whether the difference constraint is satisfied. For example, the difference constraint is difference between predicated values of the physical characteristic using the data MD13 and the data CD13.

Step S345 involves responsive to the difference constraint not being satisfied, adjusting the initial values of the model parameters based on a gradient descent of the difference constraint with respect to the model parameters such that the difference constraint is satisfied. In an embodiment, the gradient descent indicating a direction in which values of the model parameters be adjusted. It can understood by a person of ordinary skill in the art that the present disclosure is not limited to gradient descent method, and any other optimization or model fitting methods may be used to determine appropriate model parameters.

In an embodiment, the determining of the model parameter further involves computing a cost function as a function of the predicted physical characteristic values and the reference measurements REF1; determining whether the cost function satisfies a desired threshold associated therewith; and adjusting the initial values of the model parameters based on the cost function to cause the cost function to be within the desired threshold, the adjusting being performed using a gradient descent of the cost function with respect to the model parameters. In an embodiment, the cost function may be error squares plus a regularization term that tries to prevent from over fitting of the model M30. In an embodiment, the model fitting is done using Lagrange multipliers configured to solve by iterating and finding the Lagrange multiplier that satisfies the constraints and minimizes the cost function.

In an embodiment, the cost function and constraints used during the training of the model are defined as follows:

minimize *cost function f(x)*
Constraint: mean($par_{tool1}$ - $par_{tool2}$)$^2$ $< \in$

During the training of a base model (having initial model parameter values) above constraints are used. During the training, measured data from the tool T1 is used as input to the base model for predicting values $par_{tool1}$ of the physical characteristics. Similarly, another measured data from the other tool T2 is used as input to the base model to predict values $par_{tool2}$ of the physical characteristics. According to the above constraints, the model parameters are configured to maintain the difference in values of the physical characteristics below an acceptable threshold. In other words, after completing the training, the model M30 predicts values of the physical characteristics using input data from different tools. The predicted difference also matches with the reference data REF1. Hence, after completing the training, the model M30 when applied predicts substantially the same values of the physical characteristics (e.g., overlay) irrespective of whether the input data is received from different tools such as the metrology tool T1 or the other metrology tool T2. Hence, consistent measurements of the physical characteristics may be obtained.

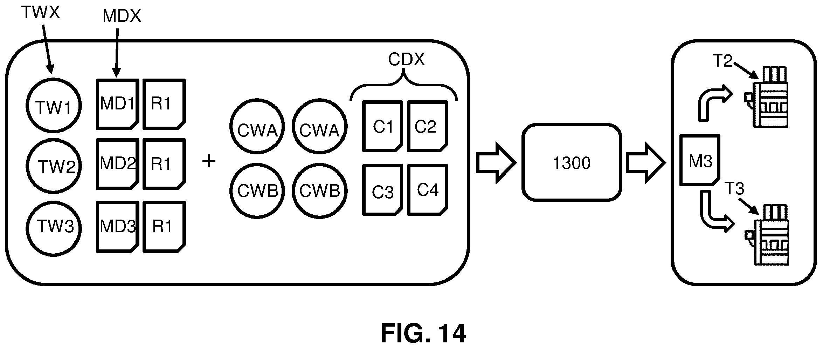

Figure 14 is another block diagram illustrating how a model configured to predict values of physical characteristics (e.g., overlay) using metrology data may be determined, according to an embodiment. In the example shown in Figure 14, determining of a model M3 is based on training data, and calibration data. In an embodiment, the training data comprising measured data MDX associated with wafers TW1, TW2, and TW3, and reference data R1 (e.g., overlay values) corresponding to each of the wafers TW1-TW3 may be obtained. In an embodiment, the measured data is obtained from a single tool T1 using the same measurement recipe or different measurement recipes. For example, the measured data MDX includes a first pupil data MD1, a second pupil data MD2, and a third pupil data MD3 obtained by light reflected from a portion of the wafers TW1, TW2, and TW3, respectively. Furthermore, the reference data R1 such as overlay values associated with wafers TW1, TW2, and TW3. In an embodiment, the reference data R1 may be obtained using a tool such as SEM or AFM.

In the present example, the calibration data may be obtained by measuring calibration wafers CWA and CWB (an example of the second set of measured data CDX) using two different metrology tools. For example, a first calibration wafer CWA may be measured using an optical metrology tool T2, and a second calibration wafer CWB may be measured using another optical metrology tool T3. In another example, the first calibration wafer CWA may be measured using both optical metrology tools T2 and T3 to generate measured data C1 and C2, respectively. Similarly, the second calibration wafer CWB may be measured using the optical metrology tools T2 and T3 to generate measured data C3 and C4 (not illustrated). In one embodiment, the measured data may be represented as intensity images obtained from reflected light from a portion of the substrates CWA and CWB. In the above example, settings or measurement recipes used with the tools T2 and T3 may be same or different. For example, a first recipe involves obtaining pupil data or intensity image using a 400-millimeter wavelength, and a second recipe involves obtaining pupil data or intensity image using a 700-millimeter wavelength.

The measured data MDX and corresponding the reference data R1, and the calibration data C1-C4 is used for determining a model M3. According to an embodiment, the model M3 is determined by the process 1300 (of Figure 13A) discussed above. For example, the process 1300 includes training the model based on the difference data computed between measured data from two different tools or the difference between predicted values of physical characteristics, as discussed with respect to the method 1300. The difference data used to train by a machine learning, or data fitting process depending on the model type (e.g., a machine learning model, or an empirical model). The trained model M3 may be used directly to predict values of the physical characteristics (e.g., overlay) using measured data from any tool such as T1 and T2. In other words, the model M3 may not be combined with tool specific information (e.g., a mapping function MF1 and MF2 of Figure 12) to allow application of the model M3.

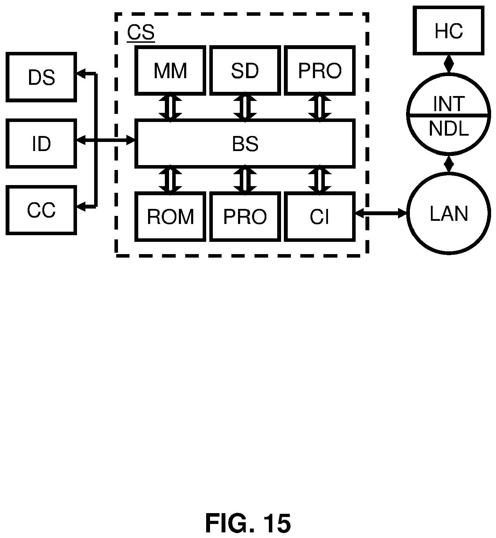

In an embodiment, the methods discussed herein may be provided as one or more computer program products or a non-transitory computer readable medium having instructions recorded thereon, the instructions when executed by a computer implementing the operation of the method 400 discussed above. For example, an example computer system CS in Figure 15 includes a non-transitory computer-readable media (e.g., memory) comprising instructions that, when executed by one or more processors (e.g., PRO), cause operations for selecting patterns from a target layout. In an embodiment, the instructions include obtaining a set of patterns; representing each pattern of the set of patterns as a group of data points in a representation domain; and selecting a subset of patterns from the set of patterns based on the groups of data points as a guide for mutual information between a given pattern and another pattern of the set of patterns.

Figure 15 is a block diagram of an example computer system CS that can perform and/or assist in implementing the methods, flows, systems or the apparatus disclosed herein, according to an embodiment. Computer system CS includes a bus BS or other communication mechanism for communicating information, and a processor PRO (or multiple processor) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions to be executed by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions contained in main memory MM causes processor PRO to perform the process steps described herein. One or more processors in a multi-processing arrangement may also be employed to execute the sequences of instructions contained in main memory MM. In an alternative embodiment, hardwired circuitry may be used in place of or in combination with software instructions. Thus, the description herein is not limited to any specific combination of hardware circuitry and software.

The term "computer-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the features described herein. Transitory computer-readable media can include a carrier wave or other propagating electromagnetic signal.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) both use electrical, electromagnetic or optical signals that carry digital data streams. The signals through the various networks and the signals on network data link NDL and through communication interface CI, which carry the digital data to and from computer system CS, are exemplary forms of carrier waves transporting the information.

Further embodiments of the present non-transitory computer-readable medium, method and metrology tool are disclosed in the subsequent list of numbered clauses:

1. A non-transitory computer-readable medium configured for determining a model configured to predict values of physical characteristics associated with a patterned substrate measured using different measurement tools, the medium comprising instructions stored therein that, when executed by one or more processors, cause operations comprising:

obtaining (i) training data comprising a first set of measured data associated with a first set of patterned substrates using a first measurement tool, and reference measurements of a physical characteristic associated with the first set of patterned substrates (ii) a second set of measured data associated with a second set of patterned substrates that is measured using a second set of measurement tools, the second set of measurement tools being different from the first measurement tool, and (iii) virtual data based on the second set of measured data, the virtual data being associated with a virtual tool;
generating a set of mapping functions between the second set of measured data and the virtual data, each mapping function mapping each measured data of the second set of measured data to the virtual data;
converting, based on the set of mapping functions, the first set of measured data of the training data; and
determining a model based on the reference measurements and the converted first set of measured data such that the model predicts values of the physical characteristic that are within an acceptable threshold of the reference measurements.

2. The medium of clause 1, wherein the first set of measured data comprises measured data in a form of signals detected by a sensor the first measurement tool configured to measure a portion of a patterned substrate of the first set of patterned substrates.

3. The medium of clause 2, wherein the first set of measured data comprises:

a first measured data detected by the sensor the first measurement tool configured to measure a portion of a first patterned substrate of the first set of patterned substrates; and
a second measured data detected by the sensor the first measurement tool configured to measure a portion of a second patterned substrate of the first set of patterned substrates.

4. The medium of clause 1, wherein each measured data of the first set of measured data comprises intensities corresponding to light reflected from a portion of a particular patterned substrate of the first set of patterned substrates.

5. The medium of clause 4, wherein the intensities comprise pixel intensities of a pixelated image generated by using a pupil for measuring the portion of the particular patterned substrate of the first set of patterned substrates.

6. The medium of clause 1, wherein the physical characteristic comprises an overlay between a feature on a first layer and a feature on a second layer of a patterned substrate; a critical dimension of features of a patterned substrate; a tilt of the patterned substrate; and/or an edge placement error associated with a pattern of the patterned substrate.

7. The medium of clause 1, wherein the reference measurements are obtained using a reference tool, the reference tool being different from the first measurement tool.

8. The medium of clause 1, wherein the reference tool is a scanning electron microscope (SEM), or a virtual tool.

9. The medium of clause 8, wherein the reference measurements of the physical characteristic are obtained by measuring the first set of patterned substrates using the SEM or an atomic force microscope (AFM).

10. The medium of clause 1, wherein the virtual data is determined by applying a mathematical operation between each of the second set of measured data.

11. The medium of clause 10, wherein the mathematical operation comprises an averaging operation applied to the second set of measured data; or a weighted averaging operation applied to the second set of measured data.

12. The medium of any of clauses 1-11, wherein generating of the set of mapping functions comprises: mapping each measured data of the second set of measured data to the virtual data, each mapping function providing a means to represent each measured data as if measured by the virtual tool.

13. The medium of any of clauses 1-12, wherein generating of the set of mapping functions comprises: determining a function for mapping each measured data of the second set of measured data to the virtual data, wherein each measured data and the virtual data are represented as pixelated images.

14. The medium of any of clauses 1-13, wherein determining of the model is an iterative process comprising:

predicting, via a base model configured with initial values of model parameters and using the converted first set of measured data as input, values of the physical characteristic associated with the first set of patterned substrate;

comparing the predicted values of the physical characteristic with the reference measurements; and

adjusting, based on the comparison, the initial values of the model parameters to cause the predicted values to be within the acceptable threshold of the reference measurements, wherein the adjusted model parameters configure the model for predicting values of the physical characteristic for any measurement tool.

15. The medium of any of clauses 1-14, further comprising:
creating, based on the set of mapping functions, recipe of the virtual tool, the recipe comprising configuration of one or more tool characteristics used during a measurement.

16. The medium of clause 15, the one or more tool characteristics comprises:

a wavelength of the light used for measurements;
a pupil shape used for measurements;
an intensity of light used for measurements; and/or
a grating-to-sensor orientation of a patterned substrate.

17. The medium of any of clauses 1-16, further comprising:

capturing, via a metrology tool, signals associated with a portion of a patterned substrate; and
executing the trained model using the captured signals as input to determine measurements of the physical characteristic associated with the patterned substrate.

18. The medium of clause 17, further comprising:

converting, via a mapping function from the set of mapping function corresponding to the metrology tool being used, the signals; and
executing the trained model using the converted signals as input to determine measurements of the physical characteristic associated with the patterned substrate.

19. The medium of any of clauses 1-18, further comprising:

transforming, based on the trained model and the set of mapping functions, a recipe of the virtual tool associated with the virtual data to recipes associated with the first measuring tool and the second measuring tool, each recipe causing the respective tool to provide consistent measurements, wherein a first recipe comprising characteristics associated with the first measurement tool, and a second recipe comprises characteristics associated with the second measurement tool.

20. A non-transitory computer-readable medium configured for determining a model configured to predict consistent values of physical characteristics associated with a patterned substrate measured using different measurement tools, the medium comprising instructions stored therein that, when executed by one or more processors, cause operations comprising:

obtaining (i) reference measurements of a physical characteristic associated with a first set of patterned substrates, (ii) first measured data associated with a portion of a second patterned substrate using a first measurement tool, and (iii) second measured data associated with the portion of the second patterned substrate using a second measurement tool; and
determining a model by adjusting model parameters based on the first measured data, the second measured data, and the reference measurements to cause the model to predict values of the physical characteristic that are within an acceptable threshold of the reference measurements.

21. The medium of clause 20, wherein determining of the model comprises:

computing a difference between the first measured data and the second measured data;
determining a set of basis functions characterizing the difference data;
applying the set of basis functions to the first measured data and the second measured data to generate projected data; and
determining the model by adjusting model parameters based on the projected data and the reference measurements to cause the model to predict values of the physical characteristic that are within the acceptable threshold of the reference measurements.

22. The medium of clause 21, wherein the set of basis functions are determined by a singular value decomposition of the difference data, or principal component analysis of the difference data.

23. The medium of clause 20, wherein determining of the model comprises:
determining model parameters by satisfying a difference constraint comprising a difference between a first predicted physical characteristic value and a second predicted physical characteristic value, the first predicted physical characteristic value being predicted using the first measured data as input to the model and the second predicted physical characteristic value being predicted using the second measured data as input to the model.

24. The medium of clause 23, wherein determining the model is an iterative process comprising:

determining, via a base model configured with initial values of the model parameters and using the first measured data and the second measured data as input, predicted physical characteristic values associated with the second patterned substrate;
determining, based on the predicted physical characteristic values, whether the difference constraint is satisfied; and
responsive to the difference constraint not being satisfied, adjusting the initial values of the model parameters based on a gradient descent of the difference constraint with respect to the model parameters such that the difference constraint is satisfied, the gradient descent indicating a direction in which values of the model parameters be adjusted.

25. The medium of clause 24, further comprising:

computing a cost function as a function of the predicted physical characteristic values and the reference measurements;
determining whether the cost function satisfies a desired threshold associated therewith; and
adjusting the initial values of the model parameters based on the cost function to cause the cost function to be within the desired threshold, the adjusting being performed using a gradient descent of the cost function with respect to the model parameters.

26. The medium of any of clauses 20-25, wherein the model is a machine learning model, or an empirical model.

27. The medium of any of clauses 20-26, wherein each of the first measured data and the second measured data comprises signals detected by sensors configured to measure the portion of the second patterned substrate.

28. The medium of any of clauses 20-27, wherein each of the first measured data and the second measured data comprises intensities corresponding to light reflected from the portion of the second patterned substrate.

29. A metrology tool comprising:

a sensor configured to detect signals associated with a portion of a patterned substrate being measured;
a processor configured to:

receive the signals from the sensor; and
determine, via a model using the signals as input, values of a physical characteristic associated with the patterned substrate, the model being configured based on measurement data associated with one or more patterned substrates measured using different metrology tools, and reference measurements of the physical characteristic associated with a reference patterned substrate.

30. The metrology tool of clause 29, wherein the physical characteristic comprises at least one of an overlay between a feature on a first layer and a feature on a second layer of the patterned substrate, a critical dimension of features of the patterned substrate, a tilt of the patterned substrate, or an edge placement error associated with the patterned substrate.

31. The metrology tool of clause 29, wherein each of the detected signal comprises intensities corresponding to light reflected from the portion of the patterned substrate being measured.

32. The metrology tool of clause 29, wherein each of the detected signal is represented as a pixelated image, one or more pixels have intensity indicative of a feature of the patterned substrate.

33. The metrology tool of clause 29, wherein the metrology tool is an optical tool configured to measure a portion of the patterned substrate.

34. The metrology tool of clause 29, wherein the metrology tool is a scanning electron microscope or an atomic force microscope configured to measure a portion of the patterned substrate.

35. The metrology tool of clause 29, wherein the model is a machine learning model, or an empirical model.

36. The metrology tool of clause 29, wherein the reference measurements of the physical characteristic are obtained by measuring the patterned substrate using a scanning electron microscope (SEM) or an atomic force microscope (AFM).

37. A method configured for determining a model configured to predict values of physical characteristics associated with a patterned substrate measured using different measurement tools, the method comprising:

obtaining (i) training data comprising a first set of measured data associated with a first set of patterned substrates using a first measurement tool, and reference measurements of a physical characteristic associated with the first set of patterned substrates (ii) a second set of measured data associated with a second set of patterned substrates that is measured using a second set of measurement tools, the second set of measurement tools being different from the first measurement tool, and (iii) virtual data based on the second set of measured data, the virtual data being associated with a virtual tool;
generating a set of mapping functions between the second set of measured data and the virtual data, each mapping function mapping each measured data of the second set of measured data to the virtual data;
converting, based on the set of mapping functions, the first set of measured data of the training data; and
determining a model based on the reference measurements and the converted first set of measured data such that the model predicts values of the physical characteristic that are within an acceptable threshold of the reference measurements.

38. The method of clause 37, wherein the first set of measured data comprises measured data in a form of signals detected by a sensor the first measurement tool configured to measure a portion of a patterned substrate of the first set of patterned substrates.

39. The method of clause 38, wherein the first set of measured data comprises:

a first measured data detected by the sensor the first measurement tool configured to measure a portion of a first patterned substrate of the first set of patterned substrates; and
a second measured data detected by the sensor the first measurement tool configured to measure a portion of a second patterned substrate of the first set of patterned substrates.

40. The method of clause 37, wherein each measured data of the first set of measured data comprises intensities corresponding to light reflected from a portion of a particular patterned substrate of the first set of patterned substrates.

41. The method of clause 40, wherein the intensities comprise pixel intensities of a pixelated image generated by using a pupil for measuring the portion of the particular patterned substrate of the first set of patterned substrates.

42. The method of clause 37, wherein the physical characteristic comprises an overlay between a feature on a first layer and a feature on a second layer of a patterned substrate; a critical dimension of features of a patterned substrate; a tilt of the patterned substrate; and/or an edge placement error associated with a pattern of the patterned substrate.

43. The method of clause 37, wherein the reference measurements are obtained using a reference tool, the reference tool being different from the first measurement tool.

44. The method of clause 43, wherein the reference tool is a scanning electron microscope (SEM), or a virtual tool.

45. The method of clause 44, wherein the reference measurements of the physical characteristic are obtained by measuring the first set of patterned substrates using the SEM or an atomic force microscope (AFM).

46. The method of clause 37, wherein the virtual data is determined by applying a mathematical operation between each of the second set of measured data.

47. The method of clause 46, wherein the mathematical operation comprises an averaging operation applied to the second set of measured data; or a weighted averaging operation applied to the second set of measured data.

48. The method of any of clauses 37-47, wherein generating of the set of mapping functions comprises:
mapping each measured data of the second set of measured data to the virtual data, each mapping function providing a means to represent each measured data as if measured by the virtual tool.

49. The method of any of clauses 37-48, wherein generating of the set of mapping functions comprises:
determining a function for mapping each measured data of the second set of measured data to the virtual data, wherein each measured data and the virtual data are represented as pixelated images.

50. The method of any of clauses 37-49, wherein determining of the model is an iterative process comprising:

predicting, via a base model configured with initial values of model parameters and using the converted first set of measured data as input, values of the physical characteristic associated with the first set of patterned substrate;
comparing the predicted values of the physical characteristic with the reference measurements; and
adjusting, based on the comparison, the initial values of the model parameters to cause the predicted values to be within the acceptable threshold of the reference measurements, wherein the adjusted model parameters configure the model for predicting values of the physical characteristic for any measurement tool.

51. The method of any of clauses 37-50, further comprising:
creating, based on the set of mapping functions, recipe of the virtual tool, the recipe comprising configuration of one or more tool characteristics used during a measurement.

52. The method of clause 51, the one or more tool characteristics comprises:

a wavelength of the light used for measurements;
a pupil shape used for measurements;
an intensity of light used for measurements; and/or
a grating-to-sensor orientation of a patterned substrate.

53. The method of any of clauses 37-52, further comprising:

capturing, via a metrology tool, signals associated with a portion of a patterned substrate; and
executing the trained model using the captured signals as input to determine measurements of the physical characteristic associated with the patterned substrate.

54. The method of clause 53, further comprising:

converting, via a mapping function from the set of mapping function corresponding to the metrology tool being used, the signals; and
executing the trained model using the converted signals as input to determine measurements of the physical characteristic associated with the patterned substrate.

55. The method of any of clauses 37-54, further comprising:
transforming, based on the trained model and the set of mapping functions, a recipe of the virtual tool associated with the virtual data to recipes associated with the first measuring tool and the second measuring tool, each recipe causing the respective tool to provide consistent measurements, wherein a first recipe comprising characteristics associated with the first measurement tool, and a second recipe comprises characteristics associated with the second measurement tool.

56. A method for determining a model configured to predict consistent values of physical characteristics associated with a patterned substrate measured using different measurement tools, the method comprising:

obtaining (i) reference measurements of a physical characteristic associated with a first set of patterned substrates, (ii) first measured data associated with a portion of a second patterned substrate using a first measurement tool, and (iii) second measured data associated with the portion of the second patterned substrate using a second measurement tool; and
determining a model by adjusting model parameters based on the first measured data, the second measured data, and the reference measurements to cause the model to predict values of the physical characteristic that are within an acceptable threshold of the reference measurements.

57. The method of clause 56, wherein determining of the model comprises:

computing a difference between the first measured data and the second measured data;
determining a set of basis functions characterizing the difference data;
applying the set of basis functions to the first measured data and the second measured data to generate projected data; and
determining the model by adjusting model parameters based on the projected data and the reference measurements to cause the model to predict values of the physical characteristic that are within the acceptable threshold of the reference measurements.

58. The method of clause 57, wherein the set of basis functions are determined by a singular value decomposition of the difference data, or principal component analysis of the difference data.

59. The method of clause 56, wherein determining of the model comprises:

determining model parameters by satisfying a difference constraint comprising a difference between a first predicted physical characteristic value and a second predicted physical characteristic value, the first predicted physical characteristic value being predicted using the first measured data as input to the model and the second predicted physical characteristic value being predicted using the second measured data as input to the model.

60. The method of clause 59, wherein determining the model is an iterative process comprising:

determining, via a base model configured with initial values of the model parameters and using the first measured data and the second measured data as input, predicted physical characteristic values associated with the second patterned substrate;
determining, based on the predicted physical characteristic values, whether the difference constraint is satisfied; and
responsive to the difference constraint not being satisfied, adjusting the initial values of the model parameters based on a gradient descent of the difference constraint with respect to the model parameters such that the difference constraint is satisfied, the gradient descent indicating a direction in which values of the model parameters be adjusted.

61. The method of clause 60, further comprising:

computing a cost function as a function of the predicted physical characteristic values and the reference measurements;
determining whether the cost function satisfies a desired threshold associated therewith; and
adjusting the initial values of the model parameters based on the cost function to cause the cost function to be within the desired threshold, the adjusting being performed using a gradient descent of the cost function with respect to the model parameters.

62. The method of any of clauses 56-61, wherein the model is a machine learning model, or an empirical model.

63. The method of any of clauses 56-62, wherein each of the first measured data and the second measured data comprises signals detected by sensors configured to measure the portion of the second patterned substrate.

64. The method of any of clauses 56-63, wherein each of the first measured data and the second measured data comprises intensities corresponding to light reflected from the portion of the second patterned substrate.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers, and/or metrology systems. In addition, the combination and sub-combinations of disclosed elements may comprise separate embodiments. For example, predicting a complex electric field image and determining a metrology metric such as overlay may be performed by the same parameterized model and/or different parameterized models. These features may comprise separate embodiments, and/or these features may be used together in the same embodiment.

Although specific reference may be made in this text to embodiments of the invention in the context of a metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A non-transitory computer-readable medium configured for determining a model configured to predict values of physical characteristics associated with a patterned substrate measured using different measurement tools, the medium comprising instructions stored therein that, when executed by one or more processors, cause operations comprising:

obtaining (i) training data comprising a first set of measured data associated with a first set of patterned substrates using a first measurement tool, and reference measurements of a physical characteristic associated with the first set of patterned substrates (ii) a second set of measured data associated with a second set of patterned substrates that is measured using a second set of measurement tools, the second set of measurement tools being different from the first measurement tool, and (iii) virtual data based on the second set of measured data, the virtual data being associated with a virtual tool; generating a set of mapping functions between the second set of measured data and the virtual data, each mapping function mapping each measured data of the second set of measured data to the virtual data; converting, based on the set of mapping functions, the first set of measured data of the training data; and determining a model based on the reference measurements and the converted first set of measured data such that the model predicts values of the physical characteristic that are within an acceptable threshold of the reference measurements.

2. A non-transitory computer-readable medium configured for determining a model configured to predict consistent values of physical characteristics associated with a patterned substrate measured using different measurement tools, the medium comprising instructions stored therein that, when executed by one or more processors, cause operations comprising:

obtaining (i) reference measurements of a physical characteristic associated with a first set of patterned substrates, (ii) first measured data associated with a portion of a second patterned substrate using a first measurement tool, and (iii) second measured data associated with the portion of the second patterned substrate using a second measurement tool; and determining a model by adjusting model parameters based on the first measured data, the second measured data, and the reference measurements to cause the model to predict values of the physical characteristic that are within an acceptable threshold of the reference measurements.

3. A metrology tool comprising:

a sensor configured to detect signals associated with a portion of a patterned substrate being measured; a processor configured to:

receive the signals from the sensor; and determine, via a model using the signals as input, values of a physical characteristic associated with the patterned substrate, the model being configured based on measurement data associated with one or more patterned substrates measured using different metrology tools, and reference measurements of the physical characteristic associated with a reference patterned substrate.

4. A method configured for determining a model configured to predict values of physical characteristics associated with a patterned substrate measured using different measurement tools, the method comprising:

obtaining (i) training data comprising a first set of measured data associated with a first set of patterned substrates using a first measurement tool, and reference measurements of a physical characteristic associated with the first set of patterned substrates (ii) a second set of measured data associated with a second set of patterned substrates that is measured using a second set of measurement tools, the second set of measurement tools being different from the first measurement tool, and (iii) virtual data based on the second set of measured data, the virtual data being associated with a virtual tool; generating a set of mapping functions between the second set of measured data and the virtual data, each mapping function mapping each measured data of the second set of measured data to the virtual data; converting, based on the set of mapping functions, the first set of measured data of the training data; and determining a model based on the reference measurements and the converted first set of measured data such that the model predicts values of the physical characteristic that are within an acceptable threshold of the reference measurements.

5. The method of claim 4, wherein the physical characteristic comprises an overlay between a feature on a first layer and a feature on a second layer of a patterned substrate; a critical dimension of features of a patterned substrate; a tilt of the patterned substrate; and/or an edge placement error associated with a pattern of the patterned substrate.

6. The method of any of claims 4-5, wherein generating of the set of mapping functions comprises:
mapping each measured data of the second set of measured data to the virtual data, each mapping function providing a means to represent each measured data as if measured by the virtual tool.

7. The method of any of claims 4-6, further comprising:
creating, based on the set of mapping functions, recipe of the virtual tool, the recipe comprising configuration of one or more tool characteristics used during a measurement.

8. The method of any of claims 4-7, further comprising:

capturing, via a metrology tool, signals associated with a portion of a patterned substrate; and executing the trained model using the captured signals as input to determine measurements of the physical characteristic associated with the patterned substrate.

9. A method for determining a model configured to predict consistent values of physical characteristics associated with a patterned substrate measured using different measurement tools, the method comprising:

obtaining (i) reference measurements of a physical characteristic associated with a first set of patterned substrates, (ii) first measured data associated with a portion of a second patterned substrate using a first measurement tool, and (iii) second measured data associated with the portion of the second patterned substrate using a second measurement tool; and
determining a model by adjusting model parameters based on the first measured data, the second measured data, and the reference measurements to cause the model to predict values of the physical characteristic that are within an acceptable threshold of the reference measurements.

10. The method of claim 9, wherein determining of the model comprises:

computing a difference between the first measured data and the second measured data;
determining a set of basis functions characterizing the difference data;
applying the set of basis functions to the first measured data and the second measured data to generate projected data; and
determining the model by adjusting model parameters based on the projected data and the reference measurements to cause the model to predict values of the physical characteristic that are within the acceptable threshold of the reference measurements.

11. The method of claim 9, wherein determining of the model comprises:
determining model parameters by satisfying a difference constraint comprising a difference between a first predicted physical characteristic value and a second predicted physical characteristic value, the first predicted physical characteristic value being predicted using the first measured data as input to the model and the second predicted physical characteristic value being predicted using the second measured data as input to the model.

12. The method of claim 11, wherein determining the model is an iterative process comprising:

determining, via a base model configured with initial values of the model parameters and using the first measured data and the second measured data as input, predicted physical characteristic values associated with the second patterned substrate;
determining, based on the predicted physical characteristic values, whether the difference constraint is satisfied; and
responsive to the difference constraint not being satisfied, adjusting the initial values of the model parameters based on a gradient descent of the difference constraint with respect to the model parameters such that the difference constraint is satisfied, the gradient descent indicating a direction in which values of the model parameters be adjusted.

13. The method of claim 12, further comprising:

computing a cost function as a function of the predicted physical characteristic values and the reference measurements;
determining whether the cost function satisfies a desired threshold associated therewith; and
adjusting the initial values of the model parameters based on the cost function to cause the cost function to be within the desired threshold, the adjusting being performed using a gradient descent of the cost function with respect to the model parameters.

14. The method of any of claims 9-13, wherein each of the first measured data and the second measured data comprises signals detected by sensors configured to measure the portion of the second patterned substrate.

**15.** The method of any of claims 9-14, wherein each of the first measured data and the second measured data comprises intensities corresponding to light reflected from the portion of the second patterned substrate.

**FIG. 1**

**FIG. 2**

**FIG. 3**

**FIG. 4**

50

52

54

FIG. 5

**FIG. 6**

FIG. 7

**FIG. 8**

$$94 \searrow \qquad 95 \searrow$$

$$I = tr\left(M_{out} R \rho_{in} R^{\dagger}\right) \qquad I = r^{\dagger}\, S\, r, \quad S = \rho^{T}{}_{in} \otimes M_{out})$$

$$95 \longrightarrow \quad I = r^{\dagger}\, S\, r$$

Example: find coefficients
that "build" $S_{ref}^{HH}$ from
$S^{HH}$, $S^{HV}$, $S^{VH}$, $S^{VV}$,
And apply to get $I_{ref}^{HH}$.

$\Rightarrow$

$$
\begin{array}{ll}
a_x & I^{HH} = r^{\dagger}\, S^{HH} r \\
b_x & I^{HV} = r^{\dagger}\, S^{HV} r \\
c_x & I^{VH} = r^{\dagger}\, S^{VH} r \\
d_x & I^{VV} = r^{\dagger}\, S^{VV} r \\
+ & \overline{\phantom{I^{VV} = r^{\dagger} S^{VV} r}} \\
\approx & I_{ref}^{HH} = r^{\dagger}\, S_{ref}^{HH}\, r
\end{array}
$$

## FIG. 9

Given:  $R = \begin{pmatrix} R_{ss} & R_{sp} \\ R_{ps} & R_{pp} \end{pmatrix}$  or  $r = \begin{pmatrix} R_{ss} \\ R_{ps} \\ R_{sp} \\ R_{pp} \end{pmatrix}$  and  $I = r^{\dagger} S r,$

1005

$$S_1 = \begin{pmatrix} 1 & 0 & 0 & 0 \\ 0 & 0 & 0 & 0 \\ 0 & 0 & 0 & 0 \\ 0 & 0 & 0 & 0 \end{pmatrix} \quad S_2 = \begin{pmatrix} 0 & 0 & 0 & 0 \\ 0 & 1 & 0 & 0 \\ 0 & 0 & 0 & 0 \\ 0 & 0 & 0 & 0 \end{pmatrix} \quad S_3 = \begin{pmatrix} 0 & 0 & 0 & 0 \\ 0 & 0 & 0 & 0 \\ 0 & 0 & 1 & 0 \\ 0 & 0 & 0 & 0 \end{pmatrix} \quad S_4 = \begin{pmatrix} 0 & 0 & 0 & 0 \\ 0 & 0 & 0 & 0 \\ 0 & 0 & 0 & 0 \\ 0 & 0 & 0 & 1 \end{pmatrix}$$

$\Downarrow$  $\Downarrow$  $\Downarrow$  $\Downarrow$

$I_1 = |R_{ss}|^2$ $\qquad I_2 = |R_{ps}|^2$ $\qquad I_1 = |R_{sp}|^2$ $\qquad I_1 = |R_{pp}|^2$

**FIG. 10A**

FIG. 10B

1007

EP 4 089 484 A1

$|R_{ss}|^2$

$|R_{sp}|^2$

$|R_{ps}|^2$

$|R_{pp}|^2$

1009

FIG. 10C

calibration data

1100

T1

T2

virtual data

TDX        CDX        VD1

training data

REF1 ──→ S11        obtaining

S13        generating

Mapping
function

MFX

S15        converting

S17        determining

M10

S18        capturing

S19        determining

**FIG. 11**

**FIG. 12**

**FIG. 13A**

S33

MD13          CD13

REF1 → S331

↓

S333

→ BF

↓

S335

→ 1310

↓

S337

↓

M30

**FIG. 13B**

**S33**

MD13    CD13

REF1 → S341

S343

S345

M30

**FIG. 13C**

**FIG. 14**

EP 4 089 484 A1

**FIG. 15**

Europäisches
Patentamt

European
Patent Office

Office européen
des brevets

## EUROPEAN SEARCH REPORT

Application Number

EP 21 17 3654

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/141193 A1 (PANDEV STILIAN IVANOV [US] ET AL) 19 May 2016 (2016-05-19) | 1-8 | INV. G03F7/20 |
| A | * paragraph [0030] - paragraph [0060] * * figures 1,2 * | 9-15 | |
| X | US 2007/268498 A1 (STANKE FRED [US] ET AL) 22 November 2007 (2007-11-22) | 9-15 | |
| A | * paragraph [0038] - paragraph [0065] * * figures 3,4 * | 1-8 | |
| A | US 2013/245985 A1 (FLOCK KLAUS [US] ET AL) 19 September 2013 (2013-09-19) * the whole document * | 1-4,9 | |

**TECHNICAL FIELDS SEARCHED (IPC)**

G03F

The present search report has been drawn up for all claims

| Place of search | Date of completion of the search | Examiner |
|---|---|---|
| Munich | 26 October 2021 | Meixner, Matthias |

EPO FORM 1503 03.82 (P04C01)

## ANNEX TO THE EUROPEAN SEARCH REPORT
## ON EUROPEAN PATENT APPLICATION NO.

EP 21 17 3654

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2021

| Patent document cited in search report | | Publication date | Patent family member(s) | Publication date |
|---|---|---|---|---|
| US 2016141193 | A1 | 19-05-2016 | CN 107077644 A<br>IL 251416 A<br>KR 20170085582 A<br>US 2016141193 A1<br>WO 2016081656 A1 | 18-08-2017<br>30-06-2019<br>24-07-2017<br>19-05-2016<br>26-05-2016 |
| US 2007268498 | A1 | 22-11-2007 | NONE | |
| US 2013245985 | A1 | 19-09-2013 | TW 201346213 A<br>US 2013245985 A1<br>WO 2013138297 A1 | 16-11-2013<br>19-09-2013<br>19-09-2013 |

EPO FORM P0459

For more details about this annex : see Official Journal of the European Patent Office, No. 12/82

**EP 4 089 484 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1